(19) Europäisches Patentamt
European Patent Office
Office européen des brevets

(11) **EP 4 624 958 A1**

(12) **EUROPEAN PATENT APPLICATION**
published in accordance with Art. 153(4) EPC

(43) Date of publication:
**01.10.2025  Bulletin 2025/40**

(21) Application number: **23894376.5**

(22) Date of filing: **31.10.2023**

(51) International Patent Classification (IPC):
**G01R 31/389** (2019.01)      **G01R 31/367** (2019.01)
**H01M 10/48** (2006.01)

(52) Cooperative Patent Classification (CPC):
**G01R 31/367; G01R 31/389; H01M 10/48;**
**Y02E 60/10**

(86) International application number:
**PCT/JP2023/039264**

(87) International publication number:
**WO 2024/111364 (30.05.2024 Gazette 2024/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.11.2022  JP 2022187173**

(71) Applicant: **Nuvoton Technology Corporation
Japan
Nagaokakyo City, Kyoto 617-8520 (JP)**

(72) Inventor: **MORI, Ryosuke
Nagaokakyo City, Kyoto 617-8520 (JP)**

(74) Representative: **Appelt, Christian W.
Boehmert & Boehmert
Anwaltspartnerschaft mbB
Pettenkoferstrasse 22
80336 München (DE)**

(54) **IMPEDANCE DETECTION DEVICE AND IMPEDANCE DETECTION METHOD**

(57)    An impedance detection device (60) includes: an obtainer (61) that obtains measurement data items on at least one of a current or a voltage at I time points in a transient response when a predetermined current or voltage is supplied to a secondary cell; and a calculator (60b) that calculates internal impedance based on the measurement data items. The calculator (60b) includes: a first calculator (62) that calculates I impedance data items by using the measurement data items; and a second calculator (60a) that calculates an element parameter of an equivalent circuit model of the secondary cell, based on the I impedance data items and an M-th degree equation in which the internal impedance is represented by a linear combination of a plurality of terms. The M-th degree equation is an equation that is based on a theoretical value and is according to the predetermined current or voltage.

FIG. 4

## Description

[Technical Field]

The present disclosure relates to an impedance detection device and an impedance detection method.

[Background Art]

The number of applications, such as electric vehicles and rechargeable batteries, that use a secondary cell has been rapidly increased. For example, a Lithium-ion Battery (LiB) is used as a secondary cell. In such an LiB, it is required that a cell state index such as a state of health (SOH), a state of power (SOP), a state of charge (SOC), or the like of a battery cell be accurately estimated for management purposes or for checking performance (checking deterioration). As a method for estimating such a cell state index, a method for estimating a cell state index by estimating an element parameter (an equivalent circuit constant) of an equivalent circuit model of a battery cell and using the element parameter estimated has been known. Patent Literature (PTL) 1 discloses a system for generating a Nyquist plot from impedance per frequency and estimating an element parameter from the Nyquist plot generated.

[Citation List]

[Patent Literature]

[PTL 1] Japanese Patent No. 6226261

[Summary of Invention]

[Technical Problem]

However, the technique disclosed in PTL 1 cannot accurately estimate an element parameter, due to the influence of an inductive component in a secondary cell or the like.

Then, the present disclosure provides an impedance detection device and an impedance detection method that can estimate an element parameter of an equivalent circuit model of a secondary cell more accurately as compared to a conventional one.

[Solution to Problem]

An impedance detection device according to an aspect of the present disclosure is an impedance detection device that detects internal impedance of a secondary cell. The impedance detection device includes: an obtainer that obtains at least one of current measurement data items or voltage measurement data items at I (I is a natural number greater than or equal to 2) time points in a transient response of the secondary cell when a predetermined current or a predetermined voltage is supplied to the secondary cell; and a calculator that calculates the internal impedance of the secondary cell, based on the at least one of the current measurement data items or the voltage measurement data items. The calculator includes: a first calculator that calculates I impedance data items by using the at least one of the voltage measurement data items or the current measurement data items; and a second calculator that calculates an element parameter of an equivalent circuit model of the secondary cell, based on the I impedance data items and an M-th (M is a natural number greater than or equal to 2) degree equation in which the internal impedance of the secondary cell is represented by a linear combination of a plurality of terms, the M-th degree equation having been obtained from the equivalent circuit model of the secondary cell. The M-th degree equation is an equation that is based on a theoretical value of the transient response of the internal impedance and is according to the predetermined current or the predetermined voltage.

An impedance detection method according to an aspect of the present disclosure is an impedance detection method for detecting internal impedance of a secondary cell. The impedance detection method includes: obtaining at least one of current measurement data items or voltage measurement data items at I (I is a natural number greater than or equal to 2) time points in a pulse response of the secondary cell when a predetermined current or a predetermined voltage is supplied to the secondary cell; and calculating the internal impedance of the secondary cell, based on the at least one of the current measurement data items or the voltage measurement data items. The calculating includes: calculating I impedance data items by using the at least one of the voltage measurement data items or the current measurement data items; and calculating an element parameter of an equivalent circuit model of the secondary cell, based on the I impedance data items and an M-th (M is a natural number greater than or equal to 2) degree equation in which the internal impedance of the secondary cell is represented by a linear combination of a plurality of terms, the M-th degree equation having been obtained from the equivalent circuit model of the secondary cell. The M-th degree equation is an equation that is based on a theoretical value of a transient response of the internal impedance and is according to the predetermined current or the predetermined voltage.

[Advantageous Effects of Invention]

An impedance detection device or the like according to an aspect of the present disclosure can estimate an element parameter of an equivalent circuit model of a secondary cell more accurately as compared to a conventional one.

[Brief Description of Drawings]

[FIG. 1]

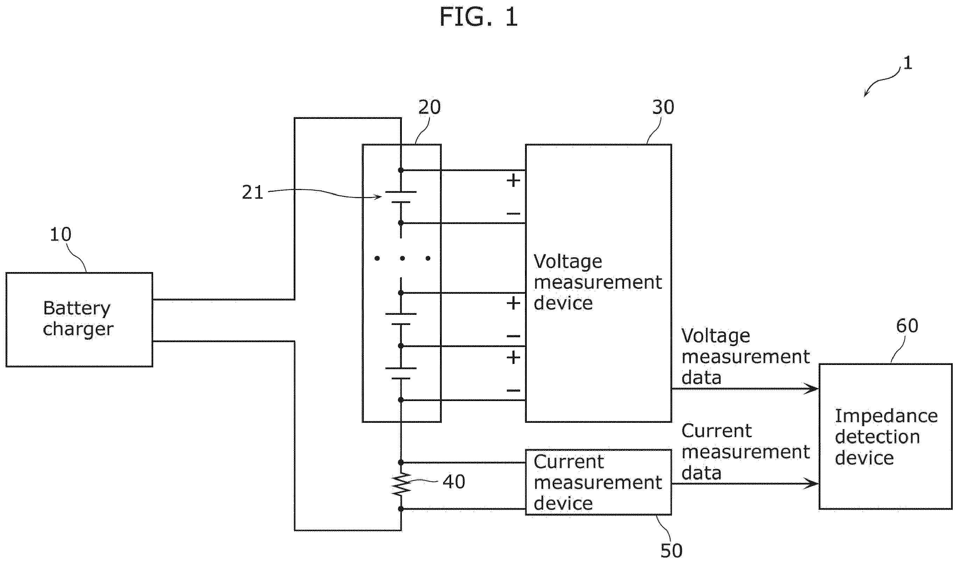

FIG. 1 illustrates a schematic configuration of an impedance detection system according to Embodiment 1.
[FIG. 2]

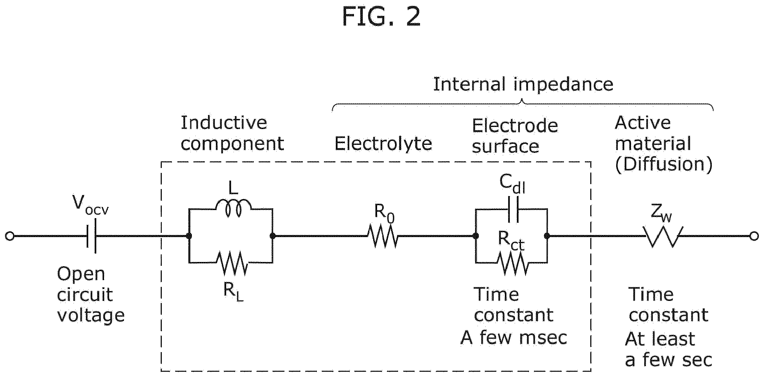

FIG. 2 illustrates an equivalent circuit model of a battery cell including internal impedance according to Embodiment 1.
[FIG. 3]

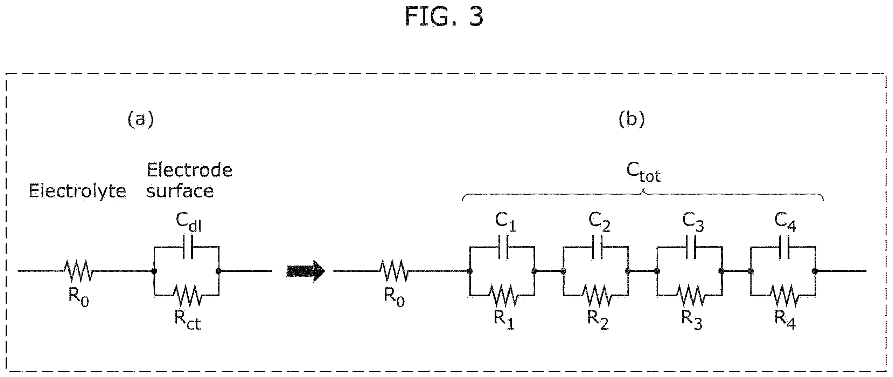

FIG. 3 illustrates a circuit in which an electrode surface component in the internal impedance according to Embodiment 1 has been replaced with serial connection of a plurality of resistor-capacitor (RC) parallel circuits.
[FIG. 4]

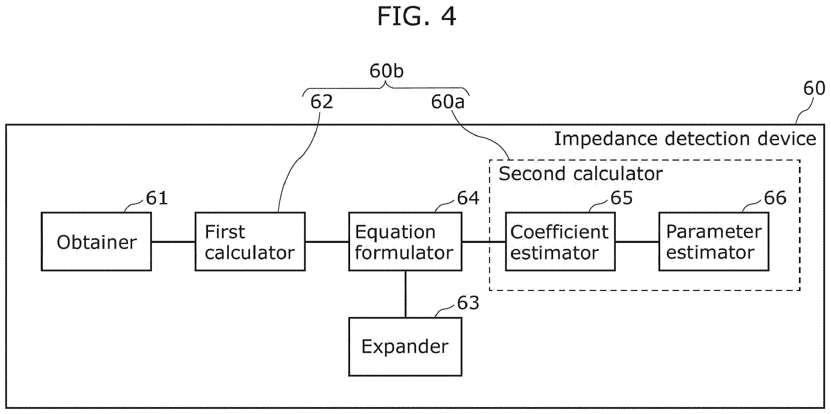

FIG. 4 is a block diagram illustrating the functional configuration of an impedance detection device according to Embodiment 1.
[FIG. 5]

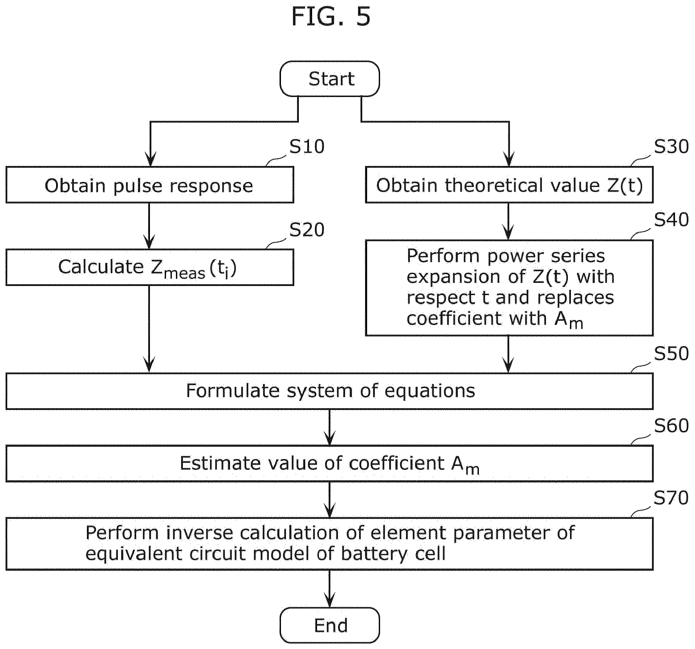

FIG. 5 is a flowchart illustrating operation of the impedance detection device according to Embodiment 1.
[FIG. 6]

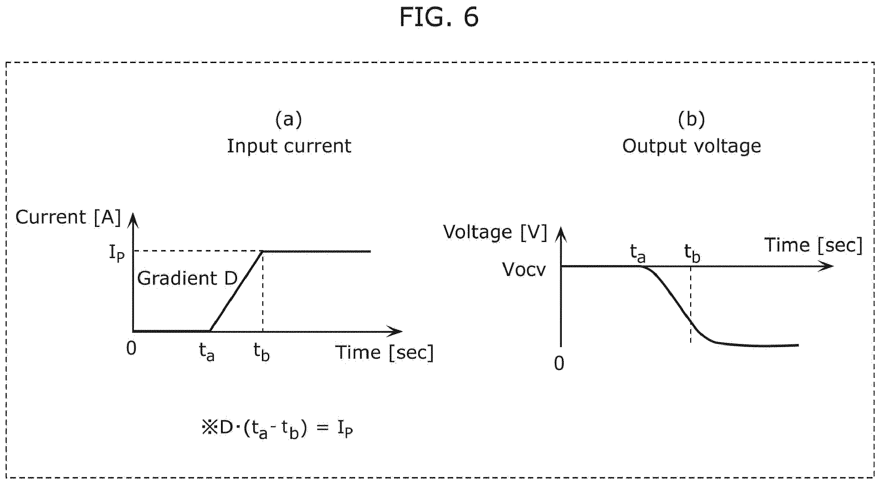

FIG. 6 schematically illustrates the shape of an input current to a battery cell according to Embodiment 2 and the shape of an output voltage from the battery cell.
[FIG. 7]

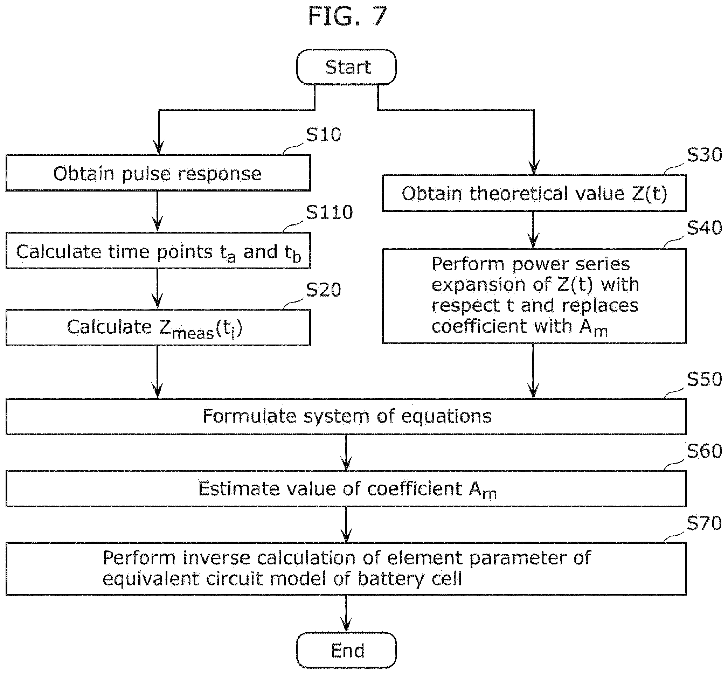

FIG. 7 is a flowchart illustrating operation of an impedance detection device according to Embodiment 2.
[FIG. 8]

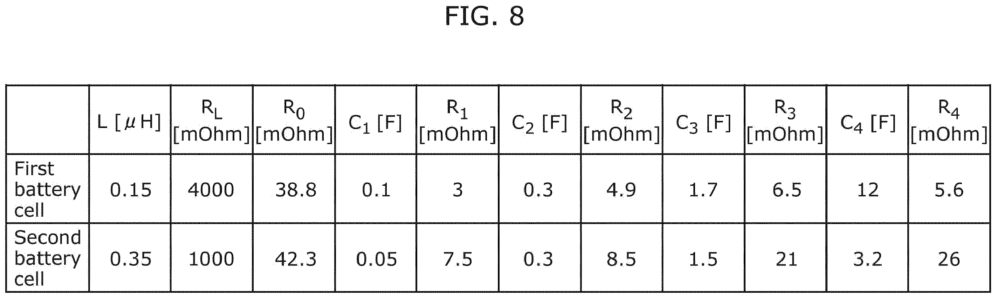

FIG. 8 illustrates battery characteristics of battery cells used in verification.
[FIG. 9A]

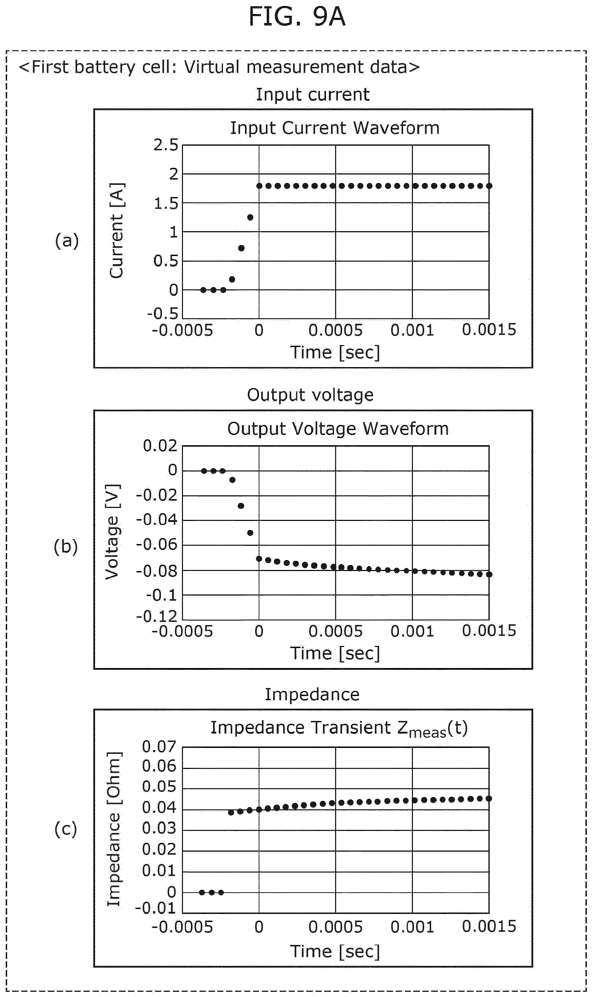

FIG. 9A illustrates various measurement data on a first battery cell.
[FIG. 9B]

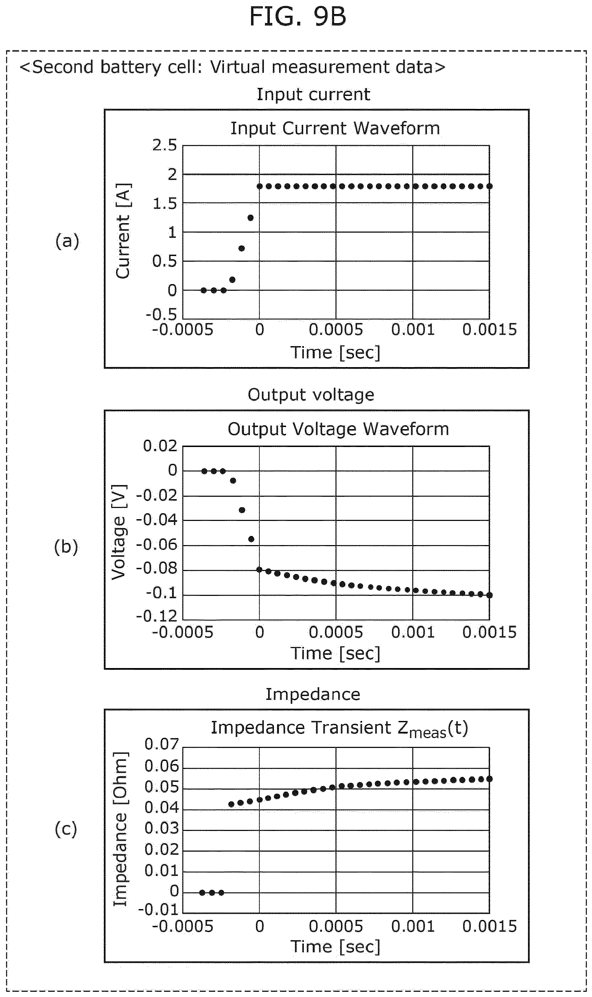

FIG. 9B illustrates various measurement data on a second battery cell.
[FIG. 10A]

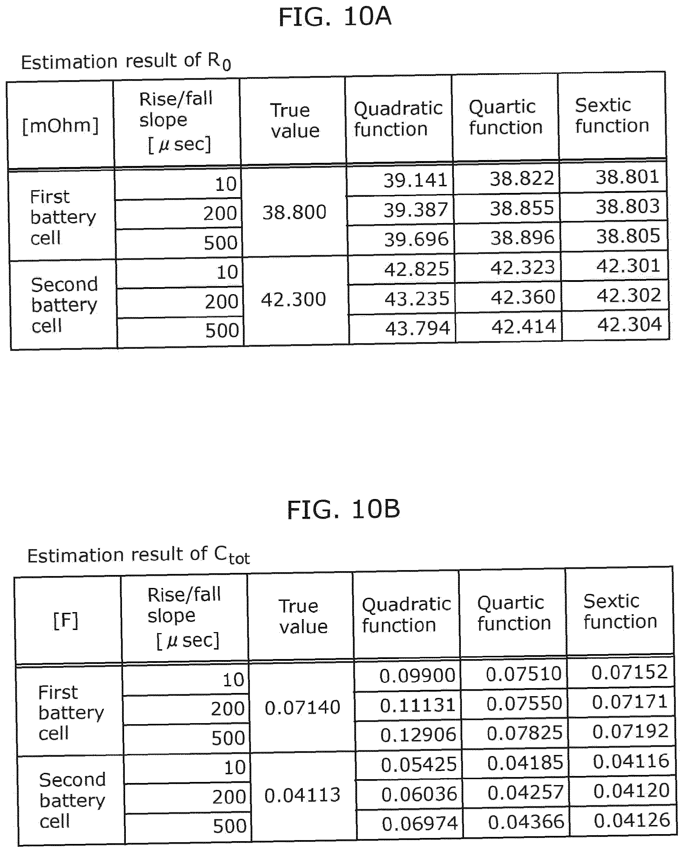

FIG. 10A illustrates estimation results of an internal parameter (series resistance $R_0$) in an impedance detection device according to the present disclosure.
[FIG. 10B]
FIG. 10B illustrates estimation results of an internal parameter (serial connection value $C_{tot}$) in the impedance detection device according to the present disclosure.
[FIG. 11A]

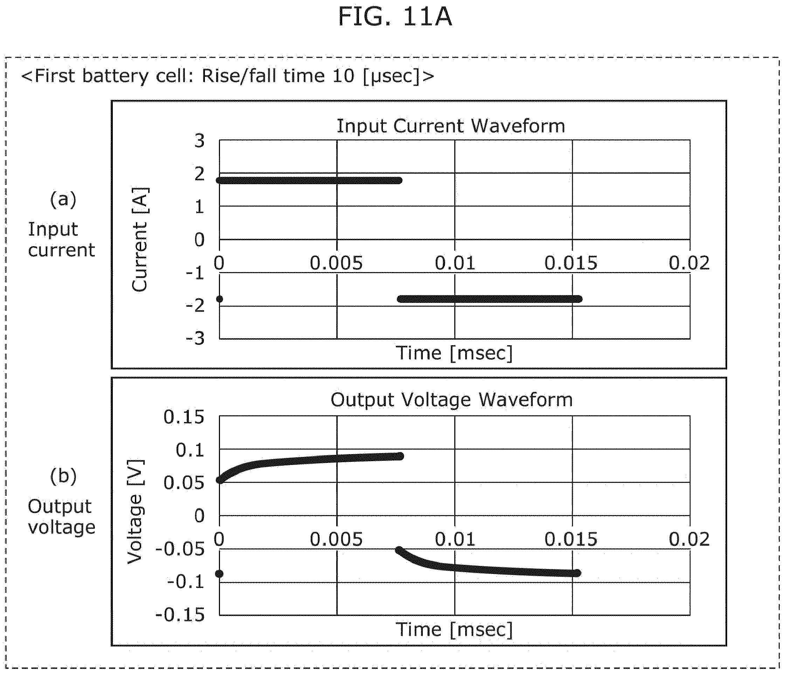

FIG. 11A illustrates a first example of measurement data on an input current and an output voltage of the first battery cell obtained by a method according to a conventional example.
[FIG. 11B]

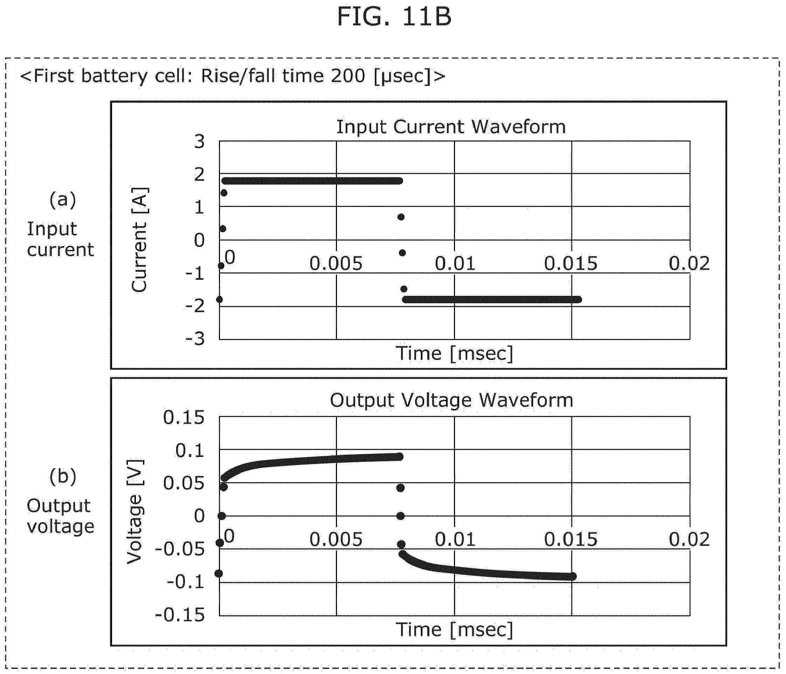

FIG. 11B illustrates a second example of measurement data on an input current and an output voltage of the first battery cell obtained by the method according to the conventional example.
[FIG. 11C]

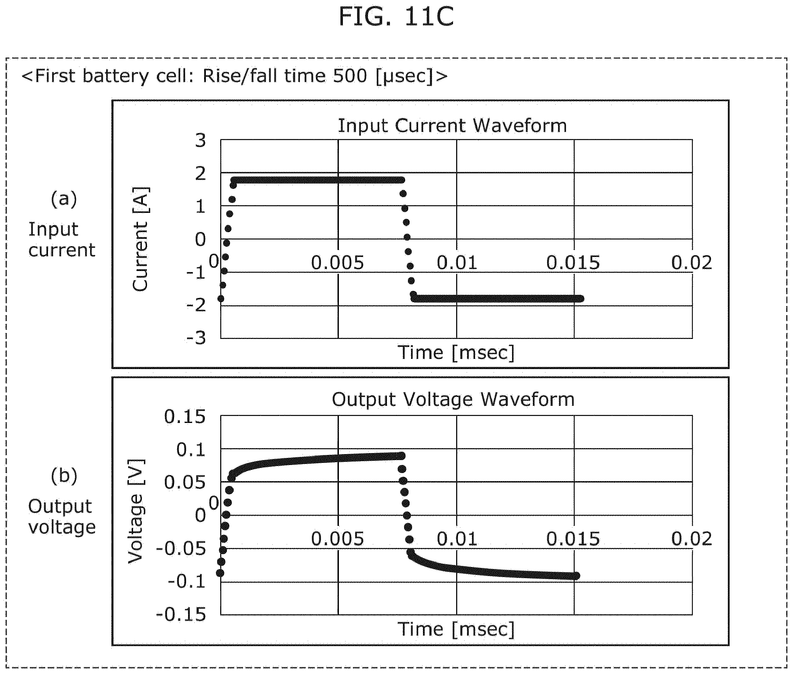

FIG. 11C illustrates a third example of measurement data on an input current and an output voltage of the first battery cell obtained by the method according to the conventional example.
[FIG. 12A]

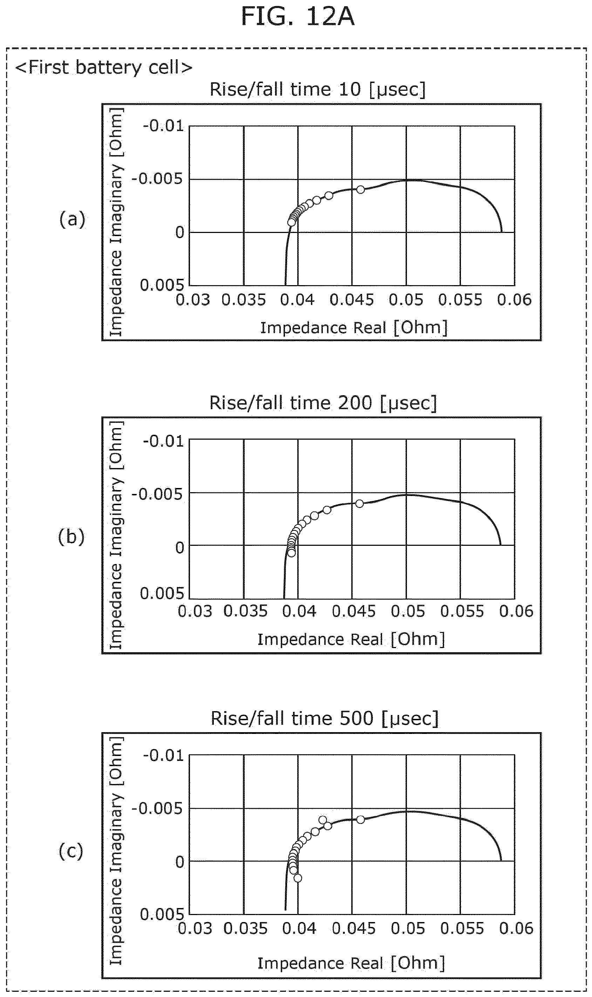

FIG. 12A illustrates Nyquist plots of the first battery cell that have been obtained by the method according to the conventional example.
[FIG. 12B]

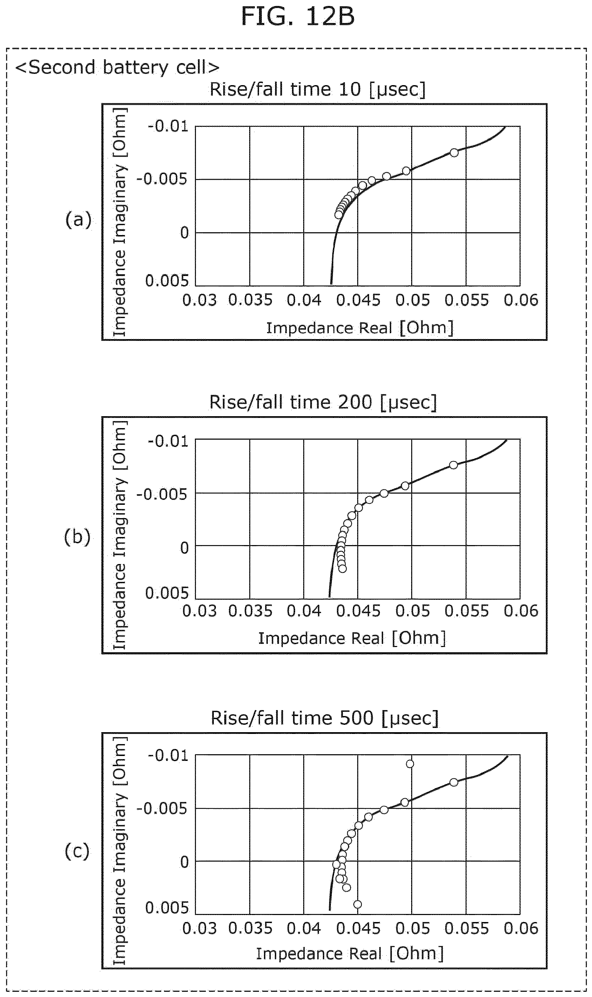

FIG. 12B illustrates Nyquist plots of the second battery cell that have been obtained by the method according to the conventional example.

[Description of Embodiments]

An impedance detection device according to an aspect of the present disclosure is an impedance detection device that detects internal impedance of a secondary cell. The impedance detection device includes: an obtainer that obtains at least one of current measurement data items or voltage measurement data items at I (I is a natural number greater than or equal to 2) time points in a transient response of the secondary cell when a predetermined current or a predetermined voltage is supplied to the secondary cell; and a calculator that calculates the internal impedance of the secondary cell, based on the at least one of the current measurement data items or the voltage measurement data items. The calculator includes: a first calculator that calculates I impedance data items by using the at least one of the voltage measurement data items or the current measurement data items; and a second calculator that calculates an element parameter of an equivalent circuit model of the secondary cell, based on the I impedance data items and an M-th (M is a natural number greater than or equal to 2) degree equation in which the internal impedance of the secondary cell is represented by a linear combination of a plurality of terms, the M-th degree equation having been obtained from the equivalent circuit model of the secondary cell. The M-th degree equation is an equation that is based on a theoretical value of the transient response of the internal impedance and is according to the predetermined current or the predetermined voltage.

Thus, since the impedance detection device can calculate the element parameter without using a Nyquist plot, the element parameter can be calculated almost without being affected by inductive reactance of the secondary cell. Accordingly, the impedance detection device according to an aspect of the present disclosure can estimate the element parameter of the equivalent circuit model of the secondary cell more accurately as compared to a conventional one.

Moreover, for example, the predetermined current or the predetermined voltage may be a pulse current or a pulse voltage.

Thus, by using a pulse response as the transient response, the element parameter of the equivalent circuit model of the secondary cell can be estimated more accurately as compared to a conventional one.

Moreover, for example, the second calculator may calculate the element parameter by assuming that the I impedance data items and the M-th degree equation are equal.

Thus, the element parameter can be calculated by substituting the I impedance data items into the M-th degree equation. Since the impedance data items do not substantially include an inductive component, the impedance detection device can estimate the element parameter of the equivalent circuit model of the secondary cell more accurately as compared to a conventional one.

Moreover, for example, the M-th degree equation may include the plurality of terms obtained by expanding the theoretical value of the transient response of the internal impedance of the secondary cell with respect to time, the theoretical value having been obtained from the equivalent circuit model of the secondary cell, the plurality of terms may include (M+1) coefficients, and the second calculator may calculate each of the (M+1) coefficients by assuming that the I impedance data items and the M-th degree equation are equal and calculate the element parameter based on the (M+1) coefficients calculated.

Thus, since the impedance detection device calculates the (M+1) coefficients in the M-th degree equation, the impedance detection device can calculate the element parameter without using a Nyquist plot.

Moreover, for example, I may be greater than (M+1), and the (M+1) coefficients may be calculated by a least-squares method.

Thus, the impedance detection device can easily perform calculation for calculating the (M+1) coefficients.

Moreover, for example, the equivalent circuit model of the secondary cell may include a configuration in which one or more parallel circuits each of which includes a capacitor and a resistor are connected in series to a series resistor, and the second calculator may calculate, as the element parameter of the secondary cell, at least resistance of the series resistor.

Thus, the impedance detection device can accurately estimate the series resistance as the element parameter.

Moreover, for example, the equivalent circuit model of the secondary cell may include a configuration in which one or more parallel circuits each of which includes a capacitor and a resistor are connected in series to a series resistor, and the second calculator may calculate, as the element parameter of the secondary cell, at least a total value of capacitance of the one or more parallel circuits.

Thus, the impedance detection device can accurately estimate the total value of capacitance as the element parameter.

Moreover, for example, the obtainer may obtain each of the current measurement data items and each of the voltage measurement data items, and the first calculator may calculate the I impedance data items by dividing each of the voltage measurement data items obtained at the I time points by, among the current measurement data items obtained at the I time points, a current measurement data item obtained at a same time point as the voltage measurement data item.

Thus, since the voltage measurement data items and the current measurement data items are used, more accurate impedance data items can be calculated. Accordingly, since the impedance detection device can estimate the element parameter by using more accurate impedance data items, the impedance detection device can calculate the element parameter more accurately.

Moreover, an impedance detection method according to an aspect of the present disclosure is an impedance detection method for detecting internal impedance of a secondary cell. The impedance detection method includes: obtaining at least one of current measurement data items or voltage measurement data items at I (I is a natural number greater than or equal to 2) time points in a pulse response of the secondary cell when a predetermined current or a predetermined voltage is supplied to the secondary cell; and calculating the internal impedance of the secondary cell, based on the at least one of the current measurement data items or the voltage measurement data items. The calculating includes: calculating I impedance data items by using the at least one of the voltage measurement data items or the current measurement data items; and calculating an element parameter of an equivalent circuit model of the secondary cell, based on the I impedance data items and an M-th (M is a natural number greater than or equal to 2) degree equation in which the internal impedance of the secondary cell is represented by a linear combination of a plurality of terms, the M-th degree equation having been obtained from the equivalent circuit model of the secondary cell. The M-th degree equation is an equation that is based on a theoretical value of a transient response of the internal impedance and is according to the predetermined current or the predetermined voltage.

Thus, an effect similar to that of the above-described impedance detection device is exhibited.

It should be noted that each of these general or specific aspects may be realized as a system, a method, an integrated circuit, a computer program, or a non-transitory computer-readable recording medium such as a CD-ROM, and may also be realized as an arbitrary combination of the system, the method, the integrated circuit, the computer program, and the recording medium. The program may be stored in a recording medium in advance or distributed to a recording medium via a wide area communication network including the Internet and the like.

Hereinafter, embodiments and the like are described in detail with reference to the Drawings.

It should be noted that each of the embodiments described below is a general or specific example. The numerical values, the constituent elements, the arrangement and connection of the constituent element, the steps, the processing order of the steps, etc. in each of the embodiments below are mere examples, and therefore do not limit the scope of the present disclosure. Moreover, among the constituent elements in each of the embodiments and the like below, a constituent element not recited in any of the independent claims is described as an arbitrary constituent element.

Furthermore, the respective figures are schematic diagrams and are not necessarily precise illustrations. Accordingly, for example, the scaling or the like depicted in the drawings is not necessarily accurate. Moreover, components that are essentially the same share like reference signs in each of the Drawings, and overlapping explanations thereof are omitted or simplified.

Furthermore, in the Specification, a word, such as equal, indicating a relationship between elements, a numerical value, and a numerical range are not intended to exactly represent the meaning thereof, and may include a range substantially the same as the meaning thereof, for example, a deviation of a few percent (e.g., approx. 10 percent).

Furthermore, in the Specification, ordinal numbers, such as "first" and "second", do not mean the number or order of constituent elements unless otherwise specified, and are used for the purpose of avoiding confusion of constituent elements of the same type and differentiating them.

(Embodiment 1)

Hereinafter, an impedance detection system including an impedance detection device according to the present embodiment is described with reference to FIG. 1 to FIG. 5.

[1-1. Configuration of Impedance Detection System]

First, a configuration of an impedance detection system according to the present embodiment is described with reference to FIG. 1. FIG. 1 illustrates a schematic configuration of impedance detection system 1 according to the present embodiment. Impedance detection system 1 according to the present embodiment can be provided to various application devices such as an electric vehicle (EV), an industrial machine, or the like.

As illustrated in FIG. 1, impedance detection system 1 includes battery charger 10, assembled battery 20, voltage measurement device 30, shunt resistor 40, current measurement device 50, and impedance detection device 60. Battery charger 10, assembled battery 20, and shunt resistor 40 are connected in series. In other words, a series circuit is formed of battery charger 10, assembled battery 20, and shunt resistor 40. Moreover, a measurement circuit that supplies a pulse current or a pulse voltage to a secondary cell and stores current measurement data items and voltage measurement data items obtained at I (I is a natural number greater than or equal to 2) time points in a pulse response of the secondary cell is configured by battery charger 10, voltage measurement device 30, shunt resistor 40, and current measurement device 50.

Battery charger 10 is a power source for supplying a pulse current or a pulse voltage to assembled battery 20. In the present embodiment, battery charger 10 supplies, to assembled battery 20, a pulse current for charging or discharging.

When battery charger 10 supplies a pulse current, data on a voltage of each of a plurality of battery cells 21 of assembled battery 20 is obtained as measurement data.

It should be noted that, in the present embodiment, a rise time and a fall time of a pulse current is assumed to be 0 seconds. Moreover, hereinafter, a pulse current is also referred to as an input current. Furthermore, a rise time and a fall time are also referred to as a pulse rise time and a pulse fall time.

Assembled battery 20 is configured by connecting the plurality of battery cells 21 in series or parallel. In the present embodiment, assembled battery 20 is configured by connecting the plurality of battery cells 21 in series. Each of the plurality of battery cells 21 is a secondary cell, for example, a lithium ion battery, and may be another secondary cell such as a nickel hydrogen battery. Assembled battery 20 functions as a power source and supplies power to a load. When impedance detection system 1 is provided to an EV, the load is, for example, a motor of the EV; however, the present disclosure is not limited to this example.

The both ends of each of the plurality of battery cells 21 are connected to voltage measurement device 30 via a plurality of voltage detection lines.

Here, an equivalent circuit model of battery cell 21 is described with reference to FIG. 2 and FIG. 3. FIG. 2 illustrates the equivalent circuit model of battery cell 21 including internal impedance according to the present embodiment. Battery cell 21 is configured to include a positive electrode, a negative electrode, and an electrolyte.

As illustrated in FIG. 2, the equivalent circuit model of battery cell 21 is formed of open circuit voltage $V_{OCV}$, an inductive component, and internal impedance. It should be noted that the inductive component may be included in the internal impedance. Moreover, the internal impedance is formed of an electrolyte component due to an electrolyte, an electrode surface component due to an electrode surface, and an active material component due to an active material.

Open circuit voltage $V_{OCV}$ is a voltage of battery cell 21 when a current does not pass through battery cell 21, and is a voltage that serves as a direct current (DC)-wise voltage source, for example.

The inductive component is formed of inductive reactance L and resistor $R_L$ that are caused by the internal impedance of battery cell 21. A time constant obtained from inductive reactance L and resistor $R_L$ is less than or equal to 1 [μsec], for example. Moreover, the width of the above-described pulse current (a time width during which one pulse current is supplied) is sufficiently longer than the time constant obtained from inductive reactance L and resistor $R_L$.

The electrolyte component is impedance due to the electrolyte itself of battery cell 21, and is a main component of series resistance $R_0$. Series resistance $R_0$ increases as the number of lithium ions decreases due to deterioration of battery cell 21.

The electrode surface component is impedance due to a surface of a positive electrode and a surface of a negative electrode, and is represented by a parallel circuit of resistor $R_{ct}$ and double layer capacitor $C_{dl}$ that is represented by a so-called constant phase element (CPE). The CPE is a virtual element for expressing the behavior of the electrolyte of battery cell 21, and impedance $Z_{CPE}$ of the CPE is represented by Equation 1 below. In Equation 1, Q denotes a constant corresponding to the capacitance of a normal capacitor, and a denotes a constant that can be any fractional value between 0 and 1.

[Math. 1]

$$Z_{CPE} = \frac{1}{(j\omega)^{\alpha}Q} \qquad \cdot \quad \cdot \quad \cdot \quad (\text{Equation 1})$$

A time constant of the impedance due to the electrode surface is a few msec.

The active material (diffusion) component is impedance due to the inside of the positive electrode and the inside of the negative electrode, and is so-called Warburg impedance $Z_W$. A time constant of the impedance due to the active material is at least a few sec, and is extremely greater than a transient response time span that is featured in impedance detection system 1. Therefore, since the active material has an extremely small influence on estimation of internal impedance according to the present disclosure, the description thereof is omitted hereinbelow.

Accordingly, in the present embodiment, it is considered that internal impedance is configured of an electrolyte component and an electrode surface component. Moreover, the electrode surface component is usually represented by serial connection of a plurality of RC parallel circuits for a mathematical analysis. An example of the serial connection of the plurality of RC parallel circuits is described with reference to FIG. 3. FIG. 3 illustrates a circuit in which the electrode surface component in internal impedance according to the present embodiment has been replaced with a serial connection of a plurality of RC parallel circuits. (a) in FIG. 3 illustrates a circuit before the electrode surface component is replaced with the serial connection of the plurality of RC parallel circuits, and (b) in FIG. 3 illustrates the circuit after the electrode surface component has been replaced with the serial connection of the plurality of RC parallel circuits.

As illustrated in (a) and (b) in FIG. 3, a single parallel circuit of resistor $R_{ct}$ and double layer capacitor $C_{dl}$ that is represented by a CPE indicating an electrode surface component is represented by a serial connection of four RC parallel circuits, for example. The four RC parallel circuits are a parallel circuit of capacitor $C_1$ and resistor $R_1$, a parallel circuit of capacitor $C_2$ and resistor $R_2$, a parallel circuit of capacitor $C_3$ and resistor $R_3$, and a parallel circuit of capacitor $C_4$ and resistor $R_4$. Moreover, the total capacitance of capacitors $C_1$ to $C_4$ is also referred to as serial connection value $C_{tot}$. Serial connection value $C_{tot}$ means a total value of the capacitance of at least one or more parallel circuits each of which includes a capacitor and a resistor.

It should be noted that the number of RC parallel circuits connected in series is a mere example and may be appropriately determined according to the type or the like of battery cell 21. It is sufficient if the number of RC parallel circuits connected in series is at least one. Thus, the equivalent circuit model of battery cell 21 has a configuration in which series resistor $R_0$ and one or more parallel circuits each of which includes a capacitor and a resistor are connected in series, and may have a configuration in which series resistor $R_0$ and two or more parallel circuits each of which includes a capacitor and a resistor are connected in series, for example.

In FIG. 1, the number of the plurality of battery cells 21 included in assembled battery 20 and a voltage of each of the plurality of battery cells 21 are not particularly limited. The plurality of battery cells 21 may be battery cells of the same standard, for example.

Voltage measurement device 30 measures a voltage of assembled battery 20. Voltage measurement device 30 is configured so that voltage measurement device 30 can measure a voltage of each of the plurality of battery cells 21 individually. Voltage measurement device 30 may be configured to include an integrated circuit (IC) for measuring a voltage of battery cell 21.

Thus, a voltage can be measured even when a voltage of entire assembled battery 20 is too high to be directly measured, and operation of each of the plurality of battery cells 21 can be individually determined. Voltage measurement device 30 measures a voltage of each of the plurality of battery cells 21 sequentially (chronologically), for example.

Shunt resistor 40 is a current detection resistor for detecting a current passing through the above-described series circuit. Shunt resistor 40 is connected in series to assembled battery 20. Shunt resistor 40 is connected between a negative side of assembled battery 20 (e.g., negative electrode of battery cell 21) and battery charger 10. The resistance value of shunt resistor 40 is not particularly limited.

Current measurement device 50 detects a current passing through assembled battery 20. Although current measurement device 50 is a resistance detection type current sensor that uses shunt resistor 40, current measurement device 50 may also be a magnetic field detection type current sensor. Current measurement device 50 may be configured to include an IC for measuring a current.

Impedance detection device 60 detects internal impedance of a secondary cell. In the present embodiment, impedance detection device 60 detects internal impedance of at least one of entire assembled battery 20 or each of the plurality of battery cells 21, based on voltage measurement data items from voltage measurement device 30 and current measurement data items from current measurement device 50.

Impedance detection device 60 estimates an element parameter of the equivalent circuit model of battery cell 21 by using a pulse response without using a method of estimating an element parameter from a Nyquist plot disclosed in PTL 1, although details thereof will be described later. In the method of estimating an element parameter from a Nyquist plot, there are instances where accuracy of estimating an element parameter is decreased under the influence of an inductive component. However, since impedance detection device 60 uses a pulse response for estimation, impedance detection device 60 is unlikely to be affected by an inductive component and can accurately estimate an element parameter.

It should be noted that estimation using a pulse response is an estimation method in which an element parameter is estimated by inputting a pulse-like current (or voltage) to battery cell 21 and measuring the input current (or input voltage) and a deviation voltage from open circuit voltage $V_{OCV}$ of battery cell 21. The estimation using a pulse response may also be referred to as a method of estimating an element parameter of the equivalent circuit model of battery cell 21 from the shape of a transient response of an IR drop (voltage drop) of the internal impedance of battery cell 21.

It should be noted that although an example in which impedance detection device 60 is provided to an EV in the same manner as the other constituent elements in impedance detection system 1 is described below, the present disclosure is not limited to this example and impedance detection device 60 may be provided separately from the other constituent elements. For example, impedance detection device 60 may be configured of a server device or the like that is communicatively connected to an EV.

FIG. 4 is a block diagram illustrating the functional configuration of impedance detection device 60 according to the present embodiment. Impedance detection device 60 can be realized by a micro-processor unit (MPU) and memory or the like. Moreover, a process performed by each of functional blocks of impedance detection device 60 is normally realized by a program execution unit, such as a processor, loading and executing software (program) recorded on a recording medium such as a ROM.

As illustrated in FIG. 4, impedance detection device 60 includes obtainer 61, first calculator 62, expander 63, equation formulator 64, coefficient estimator 65, and parameter estimator 66. Moreover, second calculator 60a is configured to include coefficient estimator 65 and parameter estimator 66, and calculator 60b is configured of first calculator 62 and second calculator 60a. Calculator 60b calculates internal impedance of battery cell 21 based on current measurement data items and voltage measurement data items.

Obtainer 61 is an interface (e.g., a hardware interface) that obtains current measurement data items and voltage measurement data items at I (I is a natural number greater than or equal to 2) time points in a pulse response of assembled battery 20 when a pulse current or a pulse voltage is supplied to assembled battery 20. Obtainer 61 obtains measurement data on a current passing through assembled battery 20 and measurement data on a voltage of each of the plurality of battery cells 21. Obtainer 61 may obtain a current measurement data item and a voltage measurement data item through wired communication (e.g., communication via a wire disposed on a substrate) or may obtain a current measurement data item and a voltage measurement data item through wireless communication.

First calculator 62 detects a rise time or fall time of an input current or input voltage, and calculates I impedance data items by dividing voltage measurement data items obtained after the rise time or fall time by current measurement data items. The voltage measurement data items and the current measurement data items are time-series data including at least measurement data items obtained at I time points, and first calculator 62 divides each of the voltage measurement data items by, among the current measurement data items, a current measurement data item obtained at the same time point as the voltage measurement data item. Moreover, I indicates the number of time points (the number of measurement points) at each of which measurement for estimating an equivalent circuit parameter is performed. It should be noted that since voltage measurement data items and current measurement data items obtained by obtainer 61 include a data item for detecting a rise time or fall time of an input current or input voltage, each of the number of voltage measurement data items obtained by obtainer 61 and the number of current measurement data items obtained by obtainer 61 is greater than I.

It should be noted that when a pulse current is supplied to assembled battery 20, in calculation of the I impedance data items, each of I voltage measurement data items may be divided by an average current calculated from I current measurement data items, or may be divided by an expected peak value of the pulse current when the expected peak value of the pulse current is known. Likewise, when a pulse voltage is supplied to assembled battery 20, in calculation of the I impedance data items, an average voltage calculated from the I voltage measurement data items may be divided by each of the I current measurement data items, or an expected peak value of the pulse voltage may be divided by each of the I current measurement data items when the expected peak value of the pulse voltage is known. It should be noted that the impedance data items do not substantially include an inductive component, for example. Each of the voltage measurement data items and the current measurement data items may be a data item obtained at a time point at which voltage measurement or current measurement is not or unlikely to be affected by an inductive component, for example.

It should be noted that detection of a rise time or fall time of the input current or input voltage may be performed by detecting, as a rise time or fall time of the input current or input voltage, a time point at which a pulse of the input current or input voltage reaches a peak value for the first time among time points in time-series measurement data on the input current or input voltage, or may be performed by another detection method. The peak value may include a margin of error and, for example, a time point at which a pulse of the input current or input voltage reaches a value within $\pm 5$ percent from an average value calculated from the I current measurement data items or from the expected peak value of the input current or input voltage may be detected as a rise time or fall time of the input current or input voltage.

Expander 63 approximates a theoretical value with an M-th (M is a natural number greater than or equal to 2) degree equation (e.g., see Equation 4 to be described later) that is obtained from the equivalent circuit model of battery cell 21 and in which internal impedance of battery cell 21 is represented by a linear combination of a plurality of terms (e.g., each term in a polynomial shown in Equation 4 to be described later). Expander 63 approximates theoretical value Z(t) of a transient response of the internal impedance of the equivalent circuit model of battery cell 21 with an M-th degree equation (see Equation 4 to be described later) represented by a plurality of terms obtained by expanding theoretical value Z(t) with respect to time (measurement time) t. Expander 63 obtains an M-th degree equation by a power series expansion of theoretical value Z(t) of a transient response with respect to time t, for example.

Equation formulator 64 formulates, based on the I impedance data items calculated by first calculator 62 and the M-th degree equation obtained by a power series expansion by expander 63, I systems of simultaneous equations for calculating each coefficient of the M-th degree equation.

Coefficient estimator 65 estimates measurement coefficients that are coefficients of the M-th degree equation by solving the I systems of simultaneous equations formulated by equation formulator 64.

Parameter estimator 66 estimates an element parameter based on the measurement coefficients of the M-th degree equation estimated and theoretical coefficients of the M-th degree equation (e.g., see Equations 5 and 6 to be described later).

[1-2. Operation of Impedance Detection Device]

Next, operation of impedance detection device 60 configured as above is described with reference to FIG. 5. FIG. 5 is a flowchart illustrating operation (impedance detection method) of impedance detection device 60 according to the present embodiment.

It should be noted that a timing at which steps S10 and S20 are performed and a timing at which steps S30 and S40 are performed in FIG. 5 are not particularly limited and may be the same, and steps S30 and S40 may be performed before step S10. Moreover, for example, the procedure in the flowchart illustrated in FIG. 5 is periodically performed. However, steps S30 and S40 are not necessarily performed every time the procedure is performed, and may be performed at least once at an arbitrary timing (e.g., only once at the first time when the procedure is performed).

As illustrated in FIG. 5, obtainer 61 obtains a measurement result of a pulse response of assembled battery 20 (S10). Obtainer 61 obtains voltage measurement data items of each of the plurality of battery cells 21 and current measurement data items including I time points. Obtainer 61 outputs, to first calculator 62, the current measurement data items and the voltage measurement data items obtained.

It should be noted that a pulse response of assembled battery 20 is caused by supplying a pulse current from battery charger 10 to assembled battery 20. Moreover, each of the I time points is a time point during which a single pulse current is supplied. Furthermore, for example, when sufficient measurement accuracy is not achieved by a single pulse response, a plurality of pulse responses may be obtained and an average value of a plurality of measurement values each of which has been obtained at the same point relative to a start time of a corresponding one of a plurality of pulse currents measured at the I time points may be obtained.

Next, first calculator 62 calculates I measurement values $Z_{meas}(ti)$ (impedance data items) by dividing the voltage measurement data items by the current measurement data items (S20). First calculator 62 outputs, to equation formulator 64, the measurement value $Z_{meas}(ti)$ calculated for each of the I time points.

Moreover, expander 63 obtains theoretical value $Z(t)$ of a transient response of the equivalent circuit model of battery cell 21 (S30). Here, theoretical value $Z(t)$ of a transient response is a theoretical value of a pulse response of internal impedance of battery cell 21. Expander 63 may obtain theoretical value $Z(t)$ of a transient response stored in storage (not illustrated) and may obtain theoretical value $Z(t)$ of a transient response via obtainer 61. Theoretical value $Z(t)$ of a transient response after a rise or fall of an input current is represented by Equation 2 below. In Equation 2, a rise time or fall time of an input current is assumed to be 0 [sec].

[Math. 2]

$$Z(t) = R_0 + \sum_n R_n \cdot (1 - e^{-\omega_{Cn} \cdot t}) \qquad \cdots \text{(Equation 2)}$$

$\omega_{Cn}$ is represented by Equation 3 below. $\omega_{Cn}$ denotes a reciprocal of a time constant.

[Math. 3]

$$\omega_{Cn} = \frac{1}{R_n \cdot C_n} \qquad \cdots \text{(Equation 3)}$$

It should be noted that an input current or an input voltage is, for example, a current or a voltage in a shape in which theoretical value $Z(t)$ of a transient response of internal impedance of battery cell 21 can be represented by an equivalent circuit parameter. The input current (e.g., a pulse current) is an example of a predetermined current, and the input voltage (e.g., a pulse voltage) is an example of a predetermined voltage.

Next, expander 63 performs a power series expansion of theoretical value $Z(t)$ with respect to time t and replaces coefficients (measurement coefficients) with coefficients $A_m$ (S40). Expander 63 approximates Equation 2 with an M-th degree equation as shown in Equation 4 by a Maclaurin expansion, for example. The Maclaurin expansion is an example of a power series expansion.

[Math. 4]

$$Z(t) \coloneqq R_0 + \sum_n R_n \cdot \left( \omega_{Cn} \cdot t - \frac{1}{2!} \cdot \omega_{Cn}{}^2 \cdot t^2 + \frac{1}{3!} \cdot \omega_{Cn}{}^3 \cdot t^3 - \frac{1}{4!} \cdot \omega_{Cn}{}^4 \cdot t^4 + \frac{1}{5!} \cdot \omega_{Cn}{}^5 \cdot t^5 - \cdots \right)$$

$$= R_0 + \left( \sum_n R_n \cdot \omega_{Cn} \right) \cdot t - \frac{1}{2!} \cdot \left( \sum_n R_n \cdot \omega_{Cn}{}^2 \right) \cdot t^2 + \frac{1}{3!} \cdot \left( \sum_n R_n \cdot \omega_{Cn}{}^3 \right) \cdot t^3 - \frac{1}{4!} \cdot \left( \sum_n R_n \cdot \omega_{Cn}{}^4 \right) \cdot t^4 + \frac{1}{5!} \cdot \left( \sum_n R_n \cdot \omega_{Cn}{}^5 \right) \cdot t^5 - \cdots$$

$$\coloneqq A_0 + A_1 \cdot t + A_2 \cdot t^2 + A_3 \cdot t^3 + A_4 \cdot t^4 + A_5 \cdot t^5 + \cdots \qquad \bullet \ \bullet \ \bullet \ (\text{Equation 4})$$

Coefficients $A_0$ and $A_m$ are represented by Equations 5 and 6 below.
[Math. 5]

$$A_0 = R_0 \qquad \bullet \ \bullet \ \bullet \ (\text{Equation 5})$$

[Math. 6]

$$A_m = \frac{(-1)^{m-1}}{m!} \cdot \left( \sum_n R_n \cdot \omega_{Cn}{}^m \right) \qquad m = 1, 2, \ldots, M \qquad \bullet \ \bullet \ \bullet \ (\text{Equation 6})$$

Each of Equations 5 and 6 is obtained by replacing the coefficients with coefficients $A_m$. Each of Equations 5 and 6 represents a relationship between coefficients $A_m$ and an element parameter. Coefficients $A_0$ and $A_m$ are an example of M+1 theoretical coefficients.

Thus, the M-th degree equation is represented by a polynomial that approximates, by a power series expansion with respect to time t (measurement time), theoretical value Z(t) of a transient response of internal impedance of battery cell 21 obtained from the equivalent circuit model of battery cell 21. Moreover, the M-th degree equation is also referred to as an equation obtained by approximating, by an expansion with respect to time, theoretical impedance obtained from the equivalent circuit model of battery cell 21. It should be noted that the M-th degree equation does not include a reactance component, for example. Moreover, the M-th degree equation is also referred to as an equation that is based on theoretical value Z(t) of a transient response of internal impedance of battery cell 21 and is according to a predetermined current or predetermined voltage.

It should be noted that degree M is appropriately selected according to the purpose or required estimation accuracy. The accuracy of estimating an element parameter can be improved by increasing degree M. Moreover, a calculation amount for estimating an element parameter can be reduced by decreasing degree M.

It should be noted that a method for expanding Equation 2 with an M-th degree equation is not limited to a Maclaurin expansion, and a power series expansion using another function may be used. The power series expansion using another function is exemplified by a Taylor series expansion, for example.

Next, equation formulator 64 formulates systems of simultaneous equations by comparing measurement values $Z_{meas}$ ($t_i$) with a power series expansion of theoretical value Z(t) with respect to time t (S50). Equation formulator 64 formulates systems of simultaneous equations based on I measurement values $Z_{meas}$ ($t_i$) calculated by first calculator 62 and the M-the degree equation obtained by expansion by expander 63. Equation formulator 64 formulates a plurality of systems of simultaneous equations shown in Equation 7, assuming that measurement value $Z_{meas}$ ($t_i$) and the M-th degree equation at the same time point are equal.
[Math. 7]

$$Z_{meas}(t_1) = A_0 + A_1 \cdot t_1 + A_2 \cdot t_1{}^2 + A_3 \cdot t_1{}^3 + A_4 \cdot t_1{}^4 + A_5 \cdot t_1{}^5 + \cdots$$
$$Z_{meas}(t_2) = A_0 + A_1 \cdot t_2 + A_2 \cdot t_2{}^2 + A_3 \cdot t_2{}^3 + A_4 \cdot t_2{}^4 + A_5 \cdot t_2{}^5 + \cdots$$
$$Z_{meas}(t_3) = A_0 + A_1 \cdot t_3 + A_2 \cdot t_3{}^2 + A_3 \cdot t_3{}^3 + A_4 \cdot t_3{}^4 + A_5 \cdot t_3{}^5 + \cdots$$

$$\bullet \ \bullet \ \bullet \ (\text{Equation 7})$$

The number of systems of simultaneous equations shown in Equation 7 is I, for example.

Next, coefficient estimator 65 estimates coefficients $A_m$ by solving the I systems of simultaneous equations formulated by equation formulator 64 (S60). Coefficient estimator 65 calculates (M+1) coefficients $A_m$ obtained when

measurement values $Z_{meas}(t_i)$ of I impedance data items are substituted into the M-th degree equation. Coefficients $A_m$ calculated by the systems of simultaneous equations using actual measurement data items is an example of measurement coefficients.

Here, coefficient estimator 65 may estimate coefficients $A_m$ by transforming Equation 7 into a matrix format and replacing the variables in Equation 7 with the letters on the right side of Equations 8 to 10 below.

[Math. 8]

$$\begin{pmatrix} Z_{meas}(t_1) \\ Z_{meas}(t_2) \\ Z_{meas}(t_3) \\ \cdot \ \cdot \ \cdot \end{pmatrix} = y \qquad \cdot \ \cdot \ \cdot \ (\text{Equation 8})$$

[Math. 9]

$$\begin{pmatrix} 1 & t_1 & t_1{}^2 & t_1{}^3 & t_1{}^4 & t_1{}^5 & \cdots \\ 1 & t_2 & t_2{}^2 & t_2{}^3 & t_2{}^4 & t_2{}^5 & \cdots \\ 1 & t_3 & t_3{}^2 & t_3{}^3 & t_3{}^4 & t_3{}^5 & \cdots \\ \cdots & \cdots & \cdots & \cdots & \cdots & \cdots & \cdots \end{pmatrix} = U \qquad \cdot \ \cdot \ \cdot \ (\text{Equation 9})$$

[Math. 10]

$$\begin{pmatrix} A_0 \\ A_1 \\ A_2 \\ A_3 \\ A_4 \\ A_5 \\ \cdots \end{pmatrix} = \theta \qquad \cdot \ \cdot \ \cdot \ (\text{Equation 10})$$

Here, when degree M of an approximate expression obtained by a power series expansion with respect to time t is smaller than I that is the number of measurement points, coefficient group $\theta$ can be estimated by using an estimation method such as a least-squares method. When coefficient group $\theta$ is estimated by a least-squares method, coefficient group $\theta$ is estimated by Equation 11 below.

[Math. 11]

$$\hat{\theta} = (U^T \cdot U)^{-1} \cdot U^T \cdot y \qquad \cdot \cdot \cdot \text{(Equation 11)}$$

Thus, an estimation value of coefficient $A_m$ can be easily calculated.

Moreover, when coefficient group $\theta$ is estimated by a least-squares method considering weight W, coefficient group $\theta$ is estimated by Equation 12 below.

[Math. 12]

$$\hat{\theta} = (U^T \cdot W \cdot U)^{-1} \cdot U^T \cdot W \cdot y \qquad \cdot \cdot \cdot \text{(Equation 12)}$$

Here, a weight matrix (I×I matrix) is represented by Equation 13 below.

[Math. 13]

$$W = \begin{pmatrix} p_1 & 0 & 0 & \cdots \\ 0 & p_2 & 0 & \cdots \\ 0 & 0 & p_3 & \cdots \\ \cdots & \cdots & \cdots & \cdots \end{pmatrix} \qquad \cdot \cdot \cdot \text{(Equation 13)}$$

It should be noted that each of $p_1, p_2, \ldots$ represents a weight of a different one of measurement points that are time points $t_1, t_2, \ldots$.

Thus, when I that is the number of measurement points is greater than (M+1), coefficient estimator 65 may estimate coefficients $A_m$ by a least-squares method.

Next, parameter estimator 66 performs an inverse calculation of each of element parameters, such as $R_0, R_n$, and $\omega_{Cn}$ (n = 1, 2, 3, ..., N), of the equivalent circuit model of each of (2N+1) battery cells 21, by using M+1 estimation values, such as $A_m$ (m = 0,1,2, ..., M), and Equations 5 and 6 (S70). In step S70, parameter estimator 66 calculates the element parameters assuming that (M+1) theoretical coefficients and (M+1) measurement coefficients are equal.

As shown in Equation 5, regarding an estimation value of series resistance $R_0$, since an estimation value of coefficient $A_0$ can be used as it is in any case, parameter estimator 66 estimates coefficient $A_0$ as series resistance $R_0$.

Moreover, when $M+1 \geq 2N+1$ is satisfied, the values of $R_n$ and the values of $\omega_{Cn}$ can be individually estimated in principle; however, in a system such as a lithium ion battery, it is generally difficult to estimate the values of $R_n$ and the values of $\omega_{Cn}$ individually since the values of $R_n$ tend to be close to each other and the values of $\omega_{Cn}$ tends to be close to each other. Then, alternatively, the value of a parameter other than series resistance $R_0$ can be calculated as $B_m$ in Equation 14 below, where m = 1, 2, ..., M.

[Math. 14]

$$B_m = \sum_n R_n \cdot \omega_{Cn}{}^m = (-1)^{m-1} \cdot m! \cdot A_m \qquad m = 1,2,\ldots,M \qquad \cdot \cdot \cdot \text{(Equation 14)}$$

Moreover, in particular, serial connection value $C_{tot}$ of capacitors C only in a serial connection of N RC parallel circuits representing an electrode surface can be estimated by Equation 15 below using an estimation value of $B_1$ in Equation 14 where m = 1.

[Math. 15]

$$C_{tot} = \left( \sum_n \frac{1}{C_n} \right)^{-1} = \left( \sum_n R_n \cdot \omega_{Cn} \right)^{-1} = \frac{1}{B_1} \qquad \cdot \cdot \cdot \text{(Equation 15)}$$

Accordingly, impedance detection device 60 can estimate series resistance $R_0$ and serial connection value $C_{tot}$ among element parameters of the equivalent circuit model of battery cell 21 illustrated in (b) in FIG. 3. It should be noted that it is sufficient if impedance detection device 60 estimates at least one of series resistance $R_0$ or serial connection value

$C_{tot}$. When the equivalent circuit model of battery cell 21 has a configuration in which one or more parallel circuits each of which includes a capacitor and a resistor are connected in series to series resistor $R_0$, impedance detection device 60 may calculate, as an element parameter of battery cell 21, at least series resistance $R_0$ and may also calculate, as an element parameter of battery cell 21, at least a total value of capacitance (serial connection value $C_{tot}$) of one or more parallel circuits each of which includes a capacitor and a resistor.

As described above, second calculator 60a calculates an element parameter of the equivalent circuit model of battery cell 21 based on (M+1) theoretical coefficients and I impedance data items.

(Embodiment 2)

Hereinbelow, an impedance detection device according to the present embodiment is described with reference to FIG. 6 and FIG. 7. It should be noted that the description is focused on the difference from Embodiment 1, and the description for the content that is the same as or similar to that of Embodiment 1 is omitted or simplified.

[2-1. Configuration of Impedance Detection System]

The configuration of an impedance detection device according to the present embodiment may be the same as that of impedance detection device 60 according to Embodiment 1, and is described using the same reference sign as that of impedance detection device 60 according to Embodiment 1. FIG. 6 schematically illustrates the shape of an input current to battery cell 21 according to the present embodiment and the shape of an output voltage from battery cell 21. (a) in FIG. 6 is a diagram illustrating an input current to battery cell 21, and (b) in FIG. 6 is a diagram illustrating an output voltage when the input current illustrated in (a) in FIG. 6 is inputted to battery cell 21.

As illustrated in (a) in FIG. 6, in the present embodiment, a pulse rise time of the input current is not 0. The input current rises from 0 [A] (0%) to Ip [A] (100%) between time point $t_a$ and time point $t_b$. Time point $t_a$ is a time point at which application of the pulse current has been started by battery charger 10. Time point $t_b$ is a time point at which the current has reached Ip. Ip is, for example, a peak value of the pulse current by battery charger 10. Moreover, change in the current is represented by gradient D, for example. Furthermore, the relationship represented by Equation 16 below is satisfied.
[Math. 16]

$$D \cdot (t_b - t_a) = I_p \qquad \cdot \ \cdot \ \cdot \ (\text{Equation 16})$$

Furthermore, in the present embodiment, a pulse fall time of the input current is also not 0.

It should be noted that $t_a = t_b$ is satisfied in the input current in Embodiment 1.

As illustrated in (b) in FIG. 6, when the input current illustrated in (a) in FIG. 6 is inputted, the voltage changes from time point $t_a$ to a time point that is after time point $t_b$.

Thus, the present embodiment is different from Embodiment 1 in rise time and fall time of input current.

[2-2. Operation of Impedance Detection Device]

Next, operation of impedance detection device 60 when the above-described input current is inputted is described with reference to FIG. 7. FIG. 7 is a flowchart illustrating operation (impedance detection method) of impedance detection device 60 according to the present embodiment.

As illustrated in FIG. 7, the impedance detection method according to the present embodiment further includes step S110 between steps S10 and S20 illustrated in FIG. 5.

After step S10, first calculator 62 calculates time points $t_a$ and $t_b$ (S110). First calculator 62 calculates time points $t_a$ and $t_b$ from time-series measurement data on a current from current measurement device 50, for example. When the waveform of the input current is unknown, first calculator 62 calculates, from measurement values of the current, gradient D and time points $t_a$ and $t_b$ in advance. Although the calculation method is exemplified by a method using a relationship between two measurement points between time points $t_a$ and $t_b$, inclusive, a least-squares method using three or more measurement points, or the like, the present disclosure is not limited to this example. It should be noted that each of time points $t_a$ and $t_b$ is a relative time point from a specific time point (0 [sec]) as a reference. For example, a time point at which obtaining of current measurement data items and voltage measurement data items is started may be used as the reference, or any one of time points $t_a$ or $t_b$ calculated at step S110 may be used as the reference.

Next, in the same manner as Embodiment 1, first calculator 62 calculates I measurement values $Z_{meas}(ti)$ (impedance data items) by dividing the voltage measurement data items by the current measurement data items (S20). Then, first calculator 62 outputs, to equation formulator 64, measurement values $Z_{meas}(ti)$ of the impedance data items calculated. Moreover, first calculator 62 outputs, to parameter estimator 66, time points $t_a$ and $t_b$ calculated.

Furthermore, expander 63 obtains theoretical value Z(t) of a transient response of the equivalent circuit model of battery cell 21 (S30). Theoretical value Z(t) of a transient response is a theoretical value of a pulse response of internal impedance of battery cell 21. Theoretical value Z(t) of a transient response after time point $t_b$ is represented by Equation 17 below.

[Math. 17]

$$Z(t) = \left( R_0 + \sum_n R_n \right) - \sum_n \frac{R_n}{\omega_{Cn}} \cdot \frac{e^{-\omega_{Cn} \cdot (t-t_b)} - e^{-\omega_{Cn} \cdot (t-t_a)}}{t_b - t_a} \qquad \cdots \text{(Equation 17)}$$

Next, expander 63 performs a power series expansion of theoretical value Z(t) of a transient response with respect to time t and replaces coefficients in Equation 17 with coefficients $A_m$ (S40). Expander 63 obtains Equations 18 and 19 by performing a Maclaurin expansion and replacing coefficients in Equation 17 with coefficients $A_m$, for example.

[Math. 18]

$$A_0 = R_0 - \sum_n \left( R_n \cdot \sum_{k=1}^{M} \frac{\omega_{Cn}^k}{(k+1)!} \cdot \frac{t_b^{k+1} - t_a^{k+1}}{t_b - t_a} \right) \qquad \cdots \text{(Equation 18)}$$

[Math. 19]

$$A_m = \frac{(-1)^{m-1}}{m!} \cdot \sum_n \left( R_n \cdot \sum_{k=0}^{M-m} \frac{\omega_{Cn}^{k+m}}{(k+1)!} \cdot \frac{t_b^{k+1} - t_a^{k+1}}{t_b - t_a} \right) \quad m = 1, 2, \ldots, M \quad \cdots \text{(Equation 19)}$$

Coefficients $A_0$ and $A_m$ are an example of M+1 theoretical coefficients.

The subsequent process is the same as Embodiment 1.

Next, coefficient estimator 65 estimates coefficients $A_m$ by solving I systems of simultaneous equations formulated by equation formulator 64 (S60). Coefficient estimator 65 calculates (M+1) coefficients $A_m$ by substituting I measurement values $Z_{meas}(ti)$ into the M-th degree equation. Coefficients $A_m$ calculated here are an example of measurement coefficients.

Next, parameter estimator 66 performs an inverse calculation of each of element parameters, such as $R_0$, $R_n$, and $\omega_{Cn}$ (n = 1, 2, 3, ..., N), of the equivalent circuit model of (2N+1) battery cells 21, by using M+1 estimation values, such as $A_m$ (m = 0, 1, 2, ..., M), Equations 18 and 19, and time points $t_a$ and $t_b$ (S70).

Parameter estimator 66 calculates $B_m$ from Equations 14 and 19, and calculates series resistance $R_0$ from Equation 18 using the value of $B_m$. Moreover, parameter estimator 66 calculates serial connection value $C_{tot}$ from Equation 15 by using $B_1$ obtained when m = 1 is satisfied in $B_m$ calculated.

It should be noted that step S110 may be omitted when a rise time and a fall time are known numbers even when the rise time and the fall time are finite values.

(Verification Result)

A result of verification of accuracy of estimating internal impedance in impedance detection device 60 according to each of the above-described embodiments is described with reference to FIG. 8 to FIG. 12B. Two battery cells 21 (a first battery cell and a second battery cell) that have mutually different battery characteristics were used for the verification. The first battery cell is battery cell 21 that is new or has been used only a few times, and the second battery cell is battery cell 21 that has deteriorated to some extent. Moreover, element parameters extracted from an actual lithium ion battery (18650 type) are assumed to be element parameters of battery cell 21 (see FIG. 8 below).

FIG. 8 illustrates the battery characteristics of battery cells 21 used in the verification. The first battery cell and the second battery cell have battery characteristics illustrated in FIG. 8. The battery characteristics of the first battery cell and the second battery cell illustrated in FIG. 8 are values estimated by an alternating current impedance method.

The element parameters include high frequency inductive components (L and $R_L$ in FIG. 8) included in battery cell 21 (e.g., lithium ion battery), for the purpose of clarifying the difference from PTL 1.

Moreover, verification was performed regarding a pulse response in which a pulse rise time and a pulse fall time of an input current are finite. Three types that are 10 [μsec], 200 [μsec], and 500 [μsec] were used as the pulse rise time and the pulse fall time. Moreover, an internal parameter estimation flow according to the present disclosure was performed regarding a battery internal impedance theoretical value as measurement data that is virtual (virtual measurement data). A high frequency inductive component included in battery cell 21 is taken into account in the virtual measurement data illustrated in FIG. 9A and the like below. For example, the virtual measurement data is data obtained from a circuit obtained by replacing a circuit of an electrode surface indicated by a broken line frame in FIG. 2 with a circuit illustrated in (b) in FIG. 3.

As an example, the virtual measurement data of the first battery cell and the second battery cell obtained when an input current peak value is 1.8 [A], time point $t_a$ is -200 [μsec], and time point $t_b$ is 0 [μsec] (rise time 200 [μsec]) is illustrated in FIG. 9A and FIG. 9B. FIG. 9A illustrates various measurement data on the first battery cell. FIG. 9B illustrates various measurement data on the second battery cell.

(a) in FIG. 9A and (a) in FIG. 9B each illustrate time-series data on an input current (current measurement data items), the horizontal axis indicates time, and the vertical axis indicates current value. The data illustrated in (a) in FIG. 9A and (a) in FIG. 9B corresponds to data obtained from current measurement device 50.

(b) in FIG. 9A and (b) in FIG. 9B each illustrate time-series data on an output voltage (voltage measurement data items), the horizontal axis indicates time, and the vertical axis indicates voltage value. The data illustrated in (b) in FIG. 9A and (b) in FIG. 9B corresponds to data obtained from voltage measurement device 30.

(c) in FIG. 9A and (c) in FIG. 9B each illustrate time-series data on impedance (internal impedance) (impedance data items), the horizontal axis indicates time, and the vertical axis indicates impedance. The data illustrated in (c) in FIG. 9A and (c) in FIG. 9B was calculated by first calculator 62. The impedance illustrated in (c) in FIG. 9A was calculated from (a) and (b) in FIG. 9A. The impedance illustrated in (c) in FIG. 9B was calculated from (a) and (b) in FIG. 9B.

It should be noted that data items after time point 0 [sec] were used for estimation of internal parameter. For example, estimation accuracy can be improved by using, for estimation of internal parameter, many data items that are close to time point 0 [sec] (e.g., data items in the first-half of the width of a pulse current). Here, "using many data items" means using more data items in the first-half of the width of a pulse current than data items in the latter-half of the width of the pulse current. Moreover, it is possible to reduce the influence of noise by using, for estimation of internal parameter, many data items that are far from time point 0 [sec] (e.g., data items in the latter-half of the width of a pulse current). Here, "using many data items" means using more data items in the latter-half of the width of a pulse current than data items in the first-half of the width of the pulse current.

It should be noted that time point 0 [sec] is a time point at which a pulse current supplied to battery cell 21 has reached a peak value (here, 1.8 [A]), and the time point corresponds to time point $t_b$ illustrated in (a) in FIG. 6, for example.

Next, an estimation result obtained when internal parameter was estimated by using a method according to the present disclosure is described with reference to FIG. 10A and FIG. 10B. FIG. 10A illustrates an estimation result of internal impedance (series resistance $R_0$) in impedance detection device 60 according to the present disclosure. FIG. 10B illustrates an estimation result of internal impedance (serial connection value $C_{tot}$) in impedance detection device 60 according to the present disclosure.

It should be noted that the power series expansions used are three types that are a quadratic function, a quartic function, and a sextic function. Moreover, time points $t_i$ are 120 [μsec], 180 [μsec], 240 [μsec], ..., 1020 [μsec], and a sampling interval is 60 [μsec]. In other words, I that is the number of measurement points is 16.

It should be noted that a weighted least-squares method was employed as a method for estimating coefficients $A_m$ at step S60, and in each of the cases of quadratic, quartic, and sextic functions, a weight was calculated by raising time point $t_i$ to the power of the reciprocal of the degree of the function. For example, in the weight matrix shown in Equation 13, $p_i = t_i^{-2}$ is satisfied in the case of a quadratic function, $p_i = t_i^{-4}$ is satisfied in the case of a quartic function, and $p_i = t_i^{-6}$ is satisfied in the case of a sextic function.

As illustrated in FIG. 10A, the measurement result of series resistance $R_0$ includes following items: rise/fall slope [μsec]; true value; quadratic function; quartic function; and sextic function.

The rise/fall slope [μsec] indicates a value between time points $t_b$ and $t_a$, that is, a rise/fall time, and there are three types of rise/fall slopes that are 10 μsec, 200 μsec, and 500 μsec.

The true value indicates series resistance $R_0$ measured by the alternating current impedance method.

Each of the quadratic function, the quartic function, and the sextic function indicates estimation results of series resistance $R_0$ that is an example of internal impedance estimated by using a corresponding one of functions in which degrees M of M-th degree equations are 2, 4, and 6.

As illustrated in FIG. 10B, the measurement result of serial connection value $C_{tot}$ includes following items: rise/fall slope [μsec]; true value; quadratic function; quartic function; and sextic function.

The rise/fall slope [μsec] indicates a value between time points $t_b$ and $t_a$, and there are three types of rise/fall slopes that are 10 μsec, 200 μsec, and 500 μsec.

The true value indicates serial connection value $C_{tot}$ measured by the alternating current impedance method.

Each of the quadratic function, the quartic function, and the sextic function indicates estimation results of serial connection value $C_{tot}$ that is an example of internal impedance estimated by using a corresponding one of functions in which degrees M of M-th degree equations are 2, 4, and 6.

It can be seen from FIG. 10A and FIG. 10B that both the first battery cell and the second battery cell have a tendency that as degree M of the M-th degree equation increases, series resistance $R_0$ and serial connection value $C_{tot}$ approaches the true value, that is, the accuracy of estimating series resistance $R_0$ and serial connection value $C_{tot}$ is improved. However, since a calculation amount increases as degree M increases, it is preferred that degree M be appropriately determined according to the necessary accuracy and the calculation amount that are required for impedance detection device 60.

Moreover, it can be seen from FIG. 10A and FIG. 10B that the difference in influence on accuracy of estimating series resistance $R_0$ and serial connection value $C_{tot}$ between different rise/fall slopes is decreased as degree M increases. For example, when degree M is 6, series resistance $R_0$ and serial connection value $C_{tot}$ are almost constant regardless of the rise/fall slope.

Moreover, it can be seen from FIG. 10A and FIG. 10B that there is almost no influence of inductive reactance L and resistor $R_L$ in the equivalent circuit model of battery cell 21 since a time constant obtained from inductive reactance L and resistor $R_L$ is smaller than the sampling interval (60 [μsec]).

Next, estimation results and the like obtained by estimating an internal parameter by a method according to a conventional example are described with reference to FIG. 11A to FIG. 12B. The method according to a conventional example is a method of estimating an element parameter from a Nyquist plot, as disclosed in PTL 1.

FIG. 11A to FIG. 11C illustrate each example of measurement data on an input current and an output voltage of the first battery cell obtained by the method according to the conventional example. FIG. 11A to FIG. 11C are different from each other in rise/fall time, the rise/fall time in FIG. 11A is 10 [μsec], the rise/fall time in FIG. 11B is 200 [μsec], and the rise/fall time in FIG. 11C is 500 [μsec]. Moreover, the sampling interval is 60 [μsec], the number of fast Fourier transform (FFT) points is 256, and the cycle of input current pulse is $60 \times 256 = 15360$ [μsec]. Furthermore, a theoretical value of an output voltage with respect to an input current of a circuit in which an inductive component shown in FIG. 2 is connected in series to the circuit illustrated in (b) in FIG. 3 was used as virtual measurement data for measurement data of an output voltage.

(a) in each of FIG. 11A to FIG. 11C indicates time-series data on an input current, the horizontal axis indicates time, and the vertical axis indicates current value. (b) in each of FIG. 11A to FIG. 11C indicates time-series data on an output voltage, the horizontal axis indicates time, and the vertical axis indicates voltage value.

As illustrated in FIG. 11A, when a rise/fall time is extremely short (here, 10 [μsec]), no rise/fall position is plotted and a rise/fall position between sampling intervals becomes uncertain.

Moreover, as illustrated in FIG. 11C, when a fall time is extremely long (here, 500 [μsec]), it is assumed that a frequency component on a high frequency side of an input current pulse becomes extremely small.

These can be factors that reduce accuracy of estimating an element parameter.

It should be noted that each example of measurement data on an input current and output voltage of the second battery cell is plotted similarly although not illustrated in the Drawings.

Next, the result of drawing Nyquist plots of the first battery cell and the second battery cell is described with reference to FIG. 12A and FIG. 12B, based on the measurement data of the first battery cell illustrated in FIG. 11A to FIG. 11C and the measurement data of the second battery cell not illustrated. FIG. 12A illustrates Nyquist plots of the first battery cell that have been obtained by the method according to the conventional example. (a) in FIG. 12A is a plot based on FIG. 11A, (b) in FIG. 12A is a plot based on FIG. 11B, and (c) in FIG. 12A is a plot based on FIG. 11C. Moreover, FIG. 12B illustrates Nyquist plots of the second battery cell that have been obtained by the method according to the conventional example. In FIG. 12A and FIG. 12B, each curve indicates values (correct data) should be plotted in the Nyquist plot, and circle plots indicate points (only 16 points on a low frequency side excluding DC) in each of the Nyquist plots obtained from the measurement data of FIG. 11A to FIG. 11C, for example.

Each of (a) in FIG. 12A and (a) in FIG. 12B illustrates a Nyquist plot obtained when the rise/fall time is 10 [μsec], each of (b) in FIG. 12A and (b) in FIG. 12B illustrates a Nyquist plot obtained when the rise/fall time is 200 [μsec], and each of (c) in FIG. 12A and (c) in FIG. 12B illustrates a Nyquist plot obtained when the rise/fall time is 500 [μsec]. Moreover, in each of FIG. 12A and FIG. 12B, the horizontal axis indicates real part of alternating current impedance and the vertical axis indicates imaginary part of alternating current impedance.

It can be seen from FIG. 12A and FIG. 12B that a Nyquist plot varies depending on the rise/fall time. For example, when a rise/fall time is extremely short (here, 10 [μsec]), a rise/fall position becomes uncertain as described above, and this is considered as one of the reasons why a Nyquist plot cannot be drawn accurately. Moreover, when a rise/fall time is extremely long (here, 500 [μsec]), a frequency component on a high frequency side of an input current pulse becomes extremely small as described above, and this is considered as one of the reasons why drawing accuracy of a Nyquist plot is decreased at a point on the high frequency side.

Furthermore, when a sampling interval (e.g., 60 [μsec]) is greater than a time constant (e.g., 1 [μsec] or less) obtained from inductive reactance L and resistor $R_L$ in the equivalent circuit model of battery cell 21, most of information on a transient response due to inductive reactance L and resistor $R_L$ cannot be sampled as an actual value and it is difficult to accurately draw a Nyquist plot on the high frequency side.

Furthermore, although information on a transient response due to inductive reactance L and resistor $R_L$ can be obtained by making a sampling interval less than or equal to the time constant, a sampling interval of an IC that is currently in practical use is approximately 60 [$\mu$sec] and it is difficult to realize an IC that operates at a sampling interval that is less than or equal to the time constant obtained from inductive reactance L and resistor $R_L$.

Thus, in the method according to the conventional example, since there is an influence of a rise/fall time and it is difficult to obtain information on a transient response due to inductive reactance L and resistor $R_L$, it is difficult to accurately draw a Nyquist plot. Moreover, when an element parameter of the equivalent circuit model of battery cell 21 is estimated by using such an inaccurate Nyquist plot, it is difficult to accurately estimate the element parameter.

In contrast, as described above, since impedance detection device 60 according to the present embodiment can estimate (e.g., calculate) an element parameter without using a Nyquist plot, it is possible to estimate (e.g., calculate) the element parameter almost without being affected by inductive reactance of battery cell 21. Accordingly, impedance detection device 60 according to an aspect of the present disclosure can estimate an element parameter of the equivalent circuit model of secondary cell 21 more accurately as compared to a conventional one.

(Other Embodiments)

Although an impedance detection device and the like according to one or more aspects of the present disclosure have been described above based on each of the embodiments and the like, the present disclosure is not limited to each of the embodiments and the like. Forms obtained by various modifications to respective embodiments that can be conceived by a person skilled in the art as well as forms realized by combining constituent elements in different embodiments may be included in the present disclosure as long as they do not depart from the essence of the present disclosure.

For example, although an example in which an impedance detection device according to each of the above-described embodiments and the like is a device that detects impedance of each of a plurality of battery cells of an assembled battery has been described, the impedance detection device according to each of the embodiments may be a device that detects impedance of an entire assembled battery by measuring voltage of the entire assembled battery by voltage measurement device 30.

Moreover, although an example in which an impedance detection device includes an expander has been described in each of the above-described embodiments and the like, the present disclosure is not limited to this example. The impedance detection device may include, instead of the expander, storage that stores an M-th degree equation expanded from a theoretical value.

Moreover, although an example in which a pulse response is used has been described in each of the above-described embodiments and the like, an element parameter may be estimated by using an impulse response or a ramp response, for example. In this case, a theoretical value corresponding to the response used is used as theoretical value Z(t) of a transient response of internal impedance used in (Equation 2). Moreover, an impulse current or a ramp current is an example of a predetermined current, and an impulse voltage or a ramp voltage is an example of a predetermined voltage.

Furthermore, a switch pulse generator (e.g., a pulse generator or the like) may be used instead of the battery charger according to each of the above-described embodiments and the like. Furthermore, a voltage waveform obtainer (e.g., an oscilloscope or the like) may be used instead of at least one of the voltage measurement device or the current measurement device according to each of the above-described embodiments and the like. Furthermore, a calculation device (e.g., a personal computer (PC) or the like) may be used instead of the impedance detection device according to each of the above-described embodiments and the like.

Furthermore, in each of the above-described embodiments and the like, each constituent element may be configured by dedicated hardware or may be realized by executing a software program suitable for each constituent element. Each constituent element may be realized by a program execution unit, such as a CPU, a processor, or the like, loading and executing a software program stored in a recording medium such as a hard disk, semiconductor memory, or the like.

Moreover, the processing order of the steps in each flowchart is an example for specifically explaining the present disclosure, and the processing order may be different from the above-described order. Furthermore, some of the steps may be executed with another step at the same time (in parallel) or some of the steps are not necessarily executed.

Furthermore, the division of the function blocks in each block diagram is a mere example. A plurality of function blocks may be realized as a single function block, a single function block may be divided into a plurality of function blocks, or part of function of a single function block may be transferred to another function block. Furthermore, functions of a plurality of function blocks that are similar to each other may be processed by a single piece of hardware or software in parallel or by time-division.

Furthermore, an impedance detection device according to each of the above-described embodiments and the like may be realized as a single device or a plurality of devices. When the impedance detection device is realized as a plurality of devices, each constituent element included in the impedance detection device may be arbitrarily assigned to

**EP 4 624 958 A1**

any of the plurality of devices. For example, a device that executes steps S10 and S20 illustrated in FIG. 5 and a device that executes steps S30 and S40 illustrated in FIG. 5 may be different. When the impedance detection device is realized as a plurality of devices, a communication method between the plurality of devices is not particularly limited, and the communication method may be wireless communication or wired communication. Moreover, wireless communication and wired communication may be performed in combination between the plurality of devices.

Furthermore, each constituent element described in the above-described embodiments and the like may be realized as software or typically realized as a Large-Scale Integration (LSI) circuit that is an integrated circuit. These constituent elements may be made into one chip individually or so that some or all of these constituent elements are included in the one chip. Here, although LSI is described as an example, the integrated circuit may also be referred to as an IC, a system LSI, a super LSI, or an ultra LSI, depending on the degree of integration. Moreover, the method of circuit integration is not limited to LSI, and integration may be realized as a dedicated circuit (a general-purpose circuit that executes a dedicated program) or a general-purpose processor. A field programmable gate array (FPGA) that allows programming after LSI manufacturing or a reconfigurable processor that allows reconfiguration of the connections or settings of circuit cells inside the LSI may be used. Moreover, if a new circuit integration technique that replaces LSI is developed from advances in or derivations of semiconductor technology, integration of the constituent elements may be performed using such a technique.

Furthermore, an aspect of the present disclosure may be a computer program that causes a computer to execute each of the characteristic steps included in the impedance detection method illustrated in any one of FIG. 5 and FIG. 7.

Furthermore, for example, the program may be a program to be executed by a computer. Furthermore, an aspect of the present disclosure may be a non-transitory computer-readable recording medium having recorded thereon such a program. For example, the recording medium having recorded thereon such a program may be distributed or circulated. For example, each of the above-described processes can be performed by a device including an other processor by installing a distributed program in the device and causing the other processor to perform the program.

[Industrial Applicability]

The present disclosure is useful in a system or the like that manages a battery.

[Reference Signs List]

1 impedance detection system
10 battery charger
20 assembled battery
21 battery cell
30 voltage measurement device
40 shunt resistor
50 voltage measurement device
60 impedance detection device
60a second calculator
60b calculator
61 obtainer
62 first calculator
63 expander
64 equation formulator
65 coefficient estimator
66 parameter estimator
$A_0$, $A_m$ coefficient (theoretical coefficient, measurement coefficient)
$C_1$, $C_2$, $C_3$, $C_4$ capacitor
$C_{dl}$ CPE
$C_{tot}$ serial connection value
I number of measurement points
L inductive reactance
M degree
$R_0$ series resistor/resistance
$R_1$, $R_2$, $R_3$, $R_4$, $R_{ct}$, $R_L$, $R_n$ resistor/resistance
t, $t_1$, $t_2$, $t_3$, $t_a$, $t_b$ time point

18

$V_{OCV}$ open circuit voltage
$Z_{meas}(ti)$ measurement value (impedance data item)
$Z(t)$ theoretical value of transient response
$Z_W$ Warburg impedance

**Claims**

1. An impedance detection device that detects internal impedance of a secondary cell, the impedance detection device comprising:

    an obtainer that obtains at least one of current measurement data items or voltage measurement data items at I time points in a transient response of the secondary cell when a predetermined current or a predetermined voltage is supplied to the secondary cell, I being a natural number greater than or equal to 2; and
    a calculator that calculates the internal impedance of the secondary cell, based on the at least one of the current measurement data items or the voltage measurement data items, wherein
    the calculator includes:

       a first calculator that calculates I impedance data items by using the at least one of the voltage measurement data items or the current measurement data items; and
       a second calculator that calculates an element parameter of an equivalent circuit model of the secondary cell, based on the I impedance data items and an M-th degree equation in which the internal impedance of the secondary cell is represented by a linear combination of a plurality of terms, the M-th degree equation having been obtained from the equivalent circuit model of the secondary cell, M being a natural number greater than or equal to 2, and

    the M-th degree equation is an equation that is based on a theoretical value of the transient response of the internal impedance and is according to the predetermined current or the predetermined voltage.

2. The impedance detection device according to claim 1, wherein
   the predetermined current or the predetermined voltage is a pulse current or a pulse voltage.

3. The impedance detection device according to claim 1 or 2, wherein
   the second calculator calculates the element parameter by assuming that the I impedance data items and the M-th degree equation are equal.

4. The impedance detection device according to claim 3, wherein

    the M-th degree equation includes the plurality of terms obtained by expanding the theoretical value of the transient response of the internal impedance of the secondary cell with respect to time, the theoretical value having been obtained from the equivalent circuit model of the secondary cell,
    the plurality of terms include (M+1) coefficients, and
    the second calculator calculates each of the (M+1) coefficients by assuming that the I impedance data items and the M-th degree equation are equal and calculates the element parameter based on the (M+1) coefficients calculated.

5. The impedance detection device according to claim 4, wherein

    I is greater than (M+1), and
    the (M+1) coefficients are calculated by a least-squares method.

6. The impedance detection device according to any one of claims 1 to 5, wherein

    the equivalent circuit model of the secondary cell includes a configuration in which one or more parallel circuits each of which includes a capacitor and a resistor are connected in series to a series resistor, and
    the second calculator calculates, as the element parameter of the secondary cell, at least resistance of the series resistor.

7. The impedance detection device according to any one of claims 1 to 5, wherein

the equivalent circuit model of the secondary cell includes a configuration in which one or more parallel circuits each of which includes a capacitor and a resistor are connected in series to a series resistor, and
the second calculator calculates, as the element parameter of the secondary cell, at least a total value of capacitance of the one or more parallel circuits.

8. The impedance detection device according to any one of claims 1 to 7, wherein

the obtainer obtains each of the current measurement data items and each of the voltage measurement data items, and
the first calculator calculates the I impedance data items by dividing each of the voltage measurement data items obtained at the I time points by, among the current measurement data items obtained at the I time points, a current measurement data item obtained at a same time point as the voltage measurement data item.

9. An impedance detection method for detecting internal impedance of a secondary cell, the impedance detection method comprising:

obtaining at least one of current measurement data items or voltage measurement data items at I time points in a pulse response of the secondary cell when a predetermined current or a predetermined voltage is supplied to the secondary cell, I being a natural number greater than or equal to 2; and
calculating the internal impedance of the secondary cell, based on the at least one of the current measurement data items or the voltage measurement data items, wherein
the calculating includes:

calculating I impedance data items by using the at least one of the voltage measurement data items or the current measurement data items; and
calculating an element parameter of an equivalent circuit model of the secondary cell, based on the I impedance data items and an M-th degree equation in which the internal impedance of the secondary cell is represented by a linear combination of a plurality of terms, the M-th degree equation having been obtained from the equivalent circuit model of the secondary cell, M being a natural number greater than or equal to 2, and

the M-th degree equation is an equation that is based on a theoretical value of a transient response of the internal impedance and is according to the predetermined current or the predetermined voltage.

EP 4 624 958 A1

# FIG. 1

# FIG. 2

EP 4 624 958 A1

FIG. 3

EP 4 624 958 A1

# FIG. 4

EP 4 624 958 A1

## FIG. 5

EP 4 624 958 A1

```
                          ┌──────────┐
                          │  Start   │
                          └──────────┘
              ┌──────────────────┴──────────────────┐
              │ S10                                  │ S30
    ┌─────────────────────────┐         ┌─────────────────────────────┐
    │  Obtain pulse response  │         │ Obtain theoretical value Z(t)│
    └─────────────────────────┘         └─────────────────────────────┘
              │ S20                                  │ S40
    ┌─────────────────────────┐         ┌─────────────────────────────┐
    │  Calculate Z_meas(t_i)  │         │ Perform power series         │
    └─────────────────────────┘         │ expansion of Z(t) with       │
                                        │ respect t and replaces       │
                                        │ coefficient with A_m         │
                                        └─────────────────────────────┘
              │                                      │ S50
    ┌───────────────────────────────────────────────────────────────┐
    │              Formulate system of equations                    │
    └───────────────────────────────────────────────────────────────┘
                                  │ S60
    ┌───────────────────────────────────────────────────────────────┐
    │              Estimate value of coefficient A_m                 │
    └───────────────────────────────────────────────────────────────┘
                                  │ S70
    ┌───────────────────────────────────────────────────────────────┐
    │  Perform inverse calculation of element parameter of          │
    │  equivalent circuit model of battery cell                     │
    └───────────────────────────────────────────────────────────────┘
                                  │
                          ┌──────────┐
                          │   End    │
                          └──────────┘
```

# FIG. 6

(a)
Input current

(b)
Output voltage

$$※D \cdot (t_a - t_b) = I_P$$

EP 4 624 958 A1

## FIG. 7

```
                          ┌──────────┐
                          │  Start   │
                          └──────────┘
              ┌───────────────┴───────────────┐
              │                               │
              ▼  S10                          ▼  S30
    ┌──────────────────────┐        ┌──────────────────────┐
    │ Obtain pulse response│        │ Obtain theoretical    │
    │                      │        │ value Z(t)            │
    └──────────────────────┘        └──────────────────────┘
              │  S110                         │  S40
              ▼                               ▼
    ┌──────────────────────┐        ┌──────────────────────┐
    │ Calculate time       │        │ Perform power series  │
    │ points $t_a$ and $t_b$ │      │ expansion of Z(t) with│
    └──────────────────────┘        │ respect t and replaces│
              │  S20                 │ coefficient with $A_m$│
              ▼                      └──────────────────────┘
    ┌──────────────────────┐                 │
    │ Calculate $Z_{meas}(t_i)$ │            │
    └──────────────────────┘                 │
              │                               │
              └───────────────┬───────────────┘
                              ▼  S50
            ┌───────────────────────────────────────┐
            │ Formulate system of equations          │
            └───────────────────────────────────────┘
                              │  S60
                              ▼
            ┌───────────────────────────────────────┐
            │ Estimate value of coefficient $A_m$    │
            └───────────────────────────────────────┘
                              │  S70
                              ▼
            ┌───────────────────────────────────────┐
            │ Perform inverse calculation of element │
            │ parameter of equivalent circuit model  │
            │ of battery cell                        │
            └───────────────────────────────────────┘
                              │
                              ▼
                          ┌──────────┐
                          │   End    │
                          └──────────┘
```

## FIG. 8

EP 4 624 958 A1

| | L [$\mu$H] | $R_L$ [mOhm] | $R_0$ [mOhm] | $C_1$ [F] | $R_1$ [mOhm] | $C_2$ [F] | $R_2$ [mOhm] | $C_3$ [F] | $R_3$ [mOhm] | $C_4$ [F] | $R_4$ [mOhm] |
|---|---|---|---|---|---|---|---|---|---|---|---|
| First battery cell | 0.15 | 4000 | 38.8 | 0.1 | 3 | 0.3 | 4.9 | 1.7 | 6.5 | 12 | 5.6 |
| Second battery cell | 0.35 | 1000 | 42.3 | 0.05 | 7.5 | 0.3 | 8.5 | 1.5 | 21 | 3.2 | 26 |

# FIG. 9A

<First battery cell: Virtual measurement data>

Input current

(a)

Output voltage

(b)

Impedance

(c)

# FIG. 9B

<Second battery cell: Virtual measurement data>

Input current

(a)

Output voltage

(b)

Impedance

(c)

# FIG. 10A

Estimation result of $R_0$

| [mOhm] | Rise/fall slope [$\mu$sec] | True value | Quadratic function | Quartic function | Sextic function |
|---|---|---|---|---|---|
| First battery cell | 10 | 38.800 | 39.141 | 38.822 | 38.801 |
|  | 200 |  | 39.387 | 38.855 | 38.803 |
|  | 500 |  | 39.696 | 38.896 | 38.805 |
| Second battery cell | 10 | 42.300 | 42.825 | 42.323 | 42.301 |
|  | 200 |  | 43.235 | 42.360 | 42.302 |
|  | 500 |  | 43.794 | 42.414 | 42.304 |

# FIG. 10B

Estimation result of $C_{tot}$

| [F] | Rise/fall slope [$\mu$sec] | True value | Quadratic function | Quartic function | Sextic function |
|---|---|---|---|---|---|
| First battery cell | 10 | 0.07140 | 0.09900 | 0.07510 | 0.07152 |
|  | 200 |  | 0.11131 | 0.07550 | 0.07171 |
|  | 500 |  | 0.12906 | 0.07825 | 0.07192 |
| Second battery cell | 10 | 0.04113 | 0.05425 | 0.04185 | 0.04116 |
|  | 200 |  | 0.06036 | 0.04257 | 0.04120 |
|  | 500 |  | 0.06974 | 0.04366 | 0.04126 |

## FIG. 11A

\<First battery cell: Rise/fall time 10 [μsec]\>

**(a) Input current**

Input Current Waveform

Current [A]

Time [msec]

**(b) Output voltage**

Output Voltage Waveform

Voltage [V]

Time [msec]

# FIG. 11B

<First battery cell: Rise/fall time 200 [μsec]>

(a) Input current

**Input Current Waveform**

Current [A] vs Time [msec]

(b) Output voltage

**Output Voltage Waveform**

Voltage [V] vs Time [msec]

# FIG. 11C

<First battery cell: Rise/fall time 500 [μsec]>

(a)

Input
current

**Input Current Waveform**

(b)

Output
voltage

**Output Voltage Waveform**

# FIG. 12A

<First battery cell>

Rise/fall time 10 [μsec]

(a)

Rise/fall time 200 [μsec]

(b)

Rise/fall time 500 [μsec]

(c)

# FIG. 12B

<Second battery cell>

(a)

### Rise/fall time 10 [μsec]

(b)

### Rise/fall time 200 [μsec]

(c)

### Rise/fall time 500 [μsec]

## INTERNATIONAL SEARCH REPORT

| International application No. |
| --- |
| **PCT/JP2023/039264** |

**A. CLASSIFICATION OF SUBJECT MATTER**

*G01R 31/389*(2019.01)i; *G01R 31/367*(2019.01)i; *H01M 10/48*(2006.01)i
FI: G01R31/389; G01R31/367; H01M10/48 P

According to International Patent Classification (IPC) or to both national classification and IPC

**B. FIELDS SEARCHED**

Minimum documentation searched (classification system followed by classification symbols)

G01R31/389; G01R31/367; H01M10/48; H01M8/04; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2005-221487 A (FURUKAWA ELECTRIC CO LTD) 18 August 2005 (2005-08-18) paragraph [0045] | 1-9 |
| A | JP 2015-135277 A (DENSO CORP) 27 July 2015 (2015-07-27) paragraph [0045] | 1-9 |
| A | CN 112345939 A (BEIJING JIAOTONG UNIVERSITY) 09 February 2021 (2021-02-09) entire text, all drawings | 1-9 |
| A | US 2019/0379092 A1 (SAMSUNG SDI CO., LTD.) 12 December 2019 (2019-12-12) entire text, all drawings | 1-9 |
| A | JP 2013-253784 A (DOSHISHA) 19 December 2013 (2013-12-19) entire text, all drawings | 1-9 |

☐ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| **12 January 2024** | **30 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2023/039264**

| Patent document cited in search report | | | Publication date (day/month/year) | Patent family member(s) | Publication date (day/month/year) |
|---|---|---|---|---|---|
| JP | 2005-221487 | A | 18 August 2005 | (Family: none) | |
| JP | 2015-135277 | A | 27 July 2015 | (Family: none) | |
| CN | 112345939 | A | 09 February 2021 | (Family: none) | |
| US | 2019/0379092 | A1 | 12 December 2019 | (Family: none) | |
| JP | 2013-253784 | A | 19 December 2013 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6226261 B